# EUROPEAN PATENT SPECIFICATION

(11) **EP 2 267 478 B1**
(45) Date of publication and mention of the grant of the patent: **22.08.2012**
(21) Application number: 10166277.3
(22) Date of filing: 17.06.2010
(51) Int. Cl.: H05K 3/12

(54) **System and method for preparing conductive structures using radiation curable phase change gel inks**
System und Verfahren zur Herstellung leitfähiger Strukturen mittels strahlungshärtbarer Phasenwechsel-Geltinten
Système et procédé de préparation de structures conductrices utilisant des encres à gel à changement de phase durcissables par radiation

(30) Priority: 23.06.2009 US 489638
(43) Date of publication of application: 29.12.2010
(73) Proprietor: Xerox Corporation, Rochester, New York 14644 (US)
(72) Inventor: Chopra, Naveen, Oakville Ontario L6H 5W4 (CA); Odell, Peter G., Mississauga Ontario L5J 1L3 (CA); Wagner, Christopher A., Etobicoke Ontario M9A 1L3 (CA); Keoshkerian, Barkev, Thornhill Ontario L4J 7E8 (CA); Chretien, Michelle, Mississauga Ontario L5M 7J5 (CA); Belelie, Jennifer L., Oakville Ontario L6N 4A5 (CA)
(74) Representative: Grünecker, Kinkeldey, Stockmair & Schwanhäusser

(56) References cited:
- WO-A2-2006/076610
- US-A1- 2004 160 465
- US-A1- 2007 123 606

## Description

### BACKGROUND

Disclosed herein is a system and method for preparing electrically conductive structures using radiation curable phase change gel inks. In embodiments, disclosed herein is a system and method for preparing electronic circuitry, for example radio frequency identification tags, using radiation curable phase change gel inks.

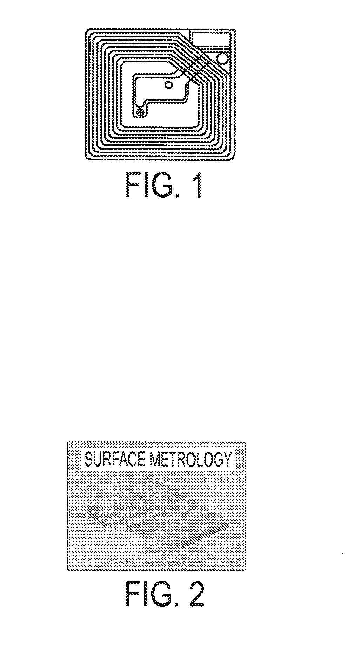

Methods used for fabrication of electronic circuitry, include, for example, subtractive methods such as foil etching or additive methods such as flexographic printing of conductive ink. Etching processes generally comprise providing an etch mask to block selected areas of a substrate surface in a desired pattern, etching the substrate to remove material not masked, and removing the masking material from the surface. An example of an etched foil radio frequency identification (RFID) tag is illustrated in FIG. 1. Foil etching is wasteful and poses environmental disadvantages since most of the material, typically aluminum or copper, is discarded.

Etch masks have been produced using ink jet printing devices. Ink jet printing devices are known in the art, and thus extensive description of such devices is not required herein.

Phase change inks are desirable for ink jet printers because they remain in a solid phase at room temperature during shipping, long term storage, and the like. In addition, the problems associated with nozzle clogging as a result of ink evaporation with liquid ink jet inks are largely eliminated, thereby improving the reliability of the ink jet printing. Further, in phase change ink jet printers wherein the ink droplets are applied directly onto the final recording substrate (for example, paper, transparency material, and the like), the droplets solidify immediately upon contact with the substrate, so that migration of ink along the printing medium is prevented and dot quality is improved.

Radiation curable inks generally comprise at least one curable monomer, a colorant, and a radiation activated initiator, specifically a photoinitiator, that initiates polymerization of curable components of the ink, specifically of the curable monomer.

U. S. Patent 7,279,587 of Peter G. Odell, Eniko Toma, and Jennifer L. Belelie, discloses photoinitiating compounds useful in curable phase change ink compositions. In embodiments, a compound of the formula

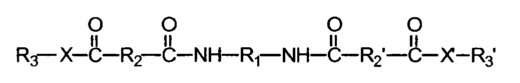

is disclosed wherein R₁ is an alkylene, arylene, arylalkylene, or alkylarylene group, R₂ and R₂' each, independently of the other, are alkylene, arylene, arylalkylene, or alkylarylene groups, R₃ and R₃' each, independently of the other, are either (a) photoinitiating groups, or (b) groups which are alkyl, aryl, arylalkyl, or alkylaryl groups, provided that at least one of R₃ and R₃' is a photoinitiating group, and X and X' each, independently of the other, is an oxygen atom or a group of the formula -NR₄-, wherein R₄ is a hydrogen atom, an alkyl group, an aryl group, an arylalkyl group, or an alkylaryl group.

U.S. Patent Publication 20070120910, Serial Number 11/290,202, Published May 31, 2007, of Peter G. Odell, Eniko Toma, and Jennifer L. Belelie, entitled "Phase Change Inks Containing Photoinitiator With Phase Change Properties and Gellant Affmity," describes, in embodiments, a phase change ink comprising a colorant, an initiator, and an ink vehicle, said ink vehicle comprising (a) at least one radically curable monomer compound, and (b) a compound of the formula

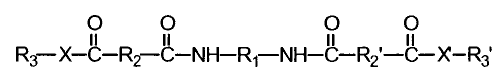

wherein R₁ is an alkylene, arylene, arylalkylene, or alkylarylene group, R₂ and R₂' each, independently of the other, are alkylene, arylene, arylalkylene, or alkylarylene groups, R₃ and R₃' each, independently of the other, are either (a) photoinitiating groups, or (b) groups which are alkyl, aryl, arylalkyl, or alkylaryl groups, provided that at least one of R₃ and R₃' is a photoinitiating group, and X and X' each, independently of the other, is an oxygen atom or a group of the formula -NR₄-, wherein R₄ is a hydrogen atom, an alkyl group, an aryl group, an arylalkyl group, or an alkylaryl group.

U.S. Patent 7,279,587 of Jennifer L. Belelie, Adela Goredema, Peter G. Odell, and Eniko Toma entitled "Method for Preparing Curable Amide Gellant Compounds," issued August 21, 2007, describes, in embodiments, a process for preparing a compound of the formula

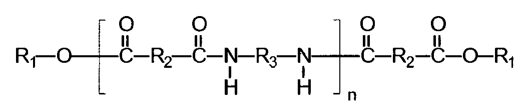

wherein R₁ is an alkyl group having at least one ethylenic unsaturation, an arylalkyl group having at least one ethylenic unsaturation, or an alkylaryl group having at least one ethylenic unsaturation, R₂ and R₃ each, independently of the others, are alkylene groups, arylene groups, arylalkylene groups, or alkylarylene groups, and n is an integer representing the number of repeat amide units and is at least 1, said process comprising: (a) reacting a diacid of the formula

HOOC-R₂-COOH

with a diamine of the formula

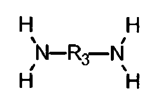

in the absence of a solvent while removing water from the reaction mixture to form an acid-terminated oligoamide intermediate; and (b) reacting the acid-terminated oligoamide intermediate with a monoalcohol of the formula

R₁-OH

in the presence of a coupling agent and a catalyst to form the product.

U.S. Patent 7,276,614 of Eniko Toma, Peter G. Odell, Adela Goredema, and Jennifer L. Belelie, entitled "Curable Amide Gellant Compounds," issued October 2, 2007, describes, in embodiments, a compound of the formula

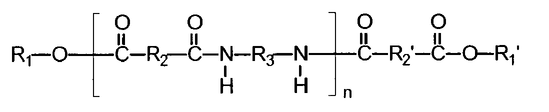

wherein R₁ and R₁' each, independently of the other, is an alkyl group having at least one ethylenic unsaturation, an arylalkyl group having at least one ethylenic unsaturation, or an alkylaryl group having at least one ethylenic unsaturation, R₂, R₂', and R₃ each, independently of the others, are alkylene groups, arylene groups, arylalkylene groups, or alkylarylene groups, and n is an integer representing the number of repeat amide units and is at least 1.

U. S. Patent Publication 20070123606, Serial Number 11/290,121, Published May 31, 2007, of Eniko Toma, Jennifer L. Belelie, and Peter G. Odell entitled "Phase Change Inks Containing Curable Amide Gellant Compounds," describes, in embodiments, a phase change ink comprising a colorant, an initiator, and a phase change ink carrier, said carrier comprising at least one radically curable monomer compound and a compound of the formula

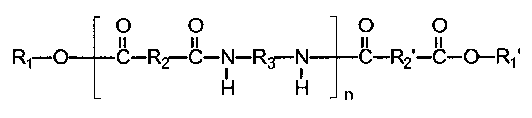

wherein R₁ and R₁' each, independently of the other, is an alkyl group having at least one ethylenic unsaturation, an arylalkyl group having at least one ethylenic unsaturation, or an alkylaryl group having at least one ethylenic unsaturation, R₂, R₂', and R₃ each, independently of the others, are alkylene groups, arylene groups, arylalkylene groups, or alkylarylene groups, and n is an integer representing the number of repeat amide units and is at least 1.

U.S. Patent 7,271,284 of Eniko Toma, Adela Goredema, Jennifer L. Belelie, and Peter G. Odell entitled "Process for Making Curable Amide Gellant Compounds," issued September 18, 2007, describes, in embodiments, a process for preparing a compound of the formula

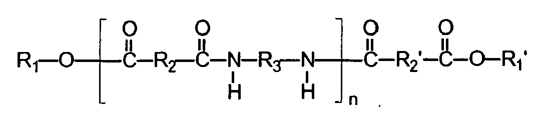

having substituents as defined therein.

U. S. Patent 6,742,884 of William S. Wong, et al., entitled "Apparatus for Printing Etch Masks Using Phase-Change Materials," is directed to a method and system for masking a surface to be etched. A droplet source ejects droplets of a masking material for deposit on a thin-film or other substrate surface to be etched. The temperature of the thin-film or substrate surface is controlled such that the droplets rapidly freeze upon contact with the thin-film or substrate surface. The thin-film or substrate is then etched. After etching the masking material is removed. See Abstract of Wong. See also U. S. Patent 6,872,320 of William S. Wong, et al., entitled "Method for Printing Etch Masks Using Phase-Change Materials,".

U. S. Patent 7,033,516 of William S. Wong, et al., entitled "Inexpensive Fabrication of Large-area Pixel Arrays For Displays And Sensors," discloses a method for fabricating an array of electronic devices, typically a display or sensor. In the method, a droplet source ejects droplets of a masking material for deposit on a thin film or substrate surface to mask element of the array of electronic devices. The temperature of the thin-film or substrate surface is controlled such that the droplets rapidly freeze upon contact with the thin-film or substrate surface. The thin-film or substrate is then etched. After etching, the masking material is removed. See Abstract of Wong.

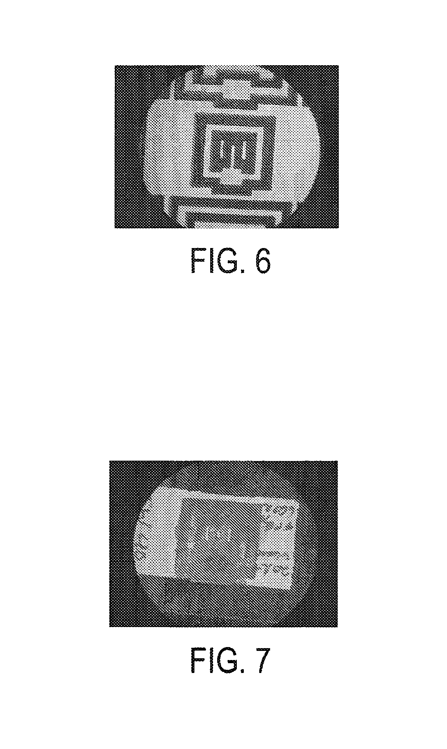

Flexographic processes can be expensive and present challenges with respect to registration of lines and pattern uniformity. See, for example, Rajiv Sangoi, et al., "Printing Radio Frequency Identification (RFID) Tag Antennas Using Inks Containing Silver Dispersions,". FIG. 2 is a surface profile of a printed RFID antenna shown in Sangoi et al. illustrating printing irregularities therein. See Fig. 6, page 517 of Sangoi et al.

The appropriate components and process aspects of the each of the foregoing U. S. Patents and Patent Publications may be selected for the present disclosure in embodiments thereof.

U. S. Patent 20040160465 discloses a method of preparing conductive structures on a substrate by printing radiation curable phase change material in a pattern of fillable channels on the surface of the substrate, curing the phase change material and depositing a conductive material in the fillable channels.

Currently available methods for preparing electronic devices are suitable for their intended purposes. However, a need remains for an improved system and method suitable for preparing conductive structures. In addition, a need remains for preparing conductive structures using thermally stable molds or dams that can withstand the elevated temperatures required for annealing conductive ink. Further, a need remains for an improved system and method for digitally preparing conductive structures.

### SUMMARY

Described is a method for preparing conductive structures on a substrate comprising printing a radiation curable phase change gel marking material in a pattern of fillable channels on a surface of a substrate; curing the radiation curable phase change gel marking material; depositing a conductive material in the fillable channels; annealing the conductive material; and optionally, removing the radiation curable phase change gel marking material.

Also described is a system for preparing conductive structures on a substrate comprising a radiation curable phase change gel marking material source to print the radiation curable phase change gel marking material in a pattern on a surface of a substrate wherein the pattern creates fillable channels; a curing device for curing the radiation curable phase change gel marking material; a conductive material source to deposit the conductive material in the fillable channels; a heat source for annealing the conductive material; and optionally, a device for removing the radiation curable phase change gel marking material.

### BRIEF DESCRIPTION OF THE DRAWINGS

Figure 1 is an illustration of an etched foil radio frequency identification tag.

Figure 2 is a surface metrology image showing surface irregularities on a portion of a printed radio frequency identification antenna.

Figure 3 is a block diagram illustrating an embodiment of the present system for preparing conductive structures using radiation curable phase change gel marking material.

Figure 4 is a flow diagram illustrating an embodiment of the present method for preparing conductive structures using radiation curable phase change gel marking material.

Figures 5A through 5D illustrate an embodiment of the present method wherein the digital dam functions as an insulating layer.

Figure 6 is a micrograph of a solid ink dam prepared by jetting solid black ink in a pattern on a substrate.

Figure 7 is a micrograph of a device prepared by jetting a printed dam pattern of solid black on a substrate, dispensing conductive ink in the dams, and annealing the conductive ink.

### DETAILED DESCRIPTION

A system and method for preparing conductive structures using radiation curable phase change gel marking material is disclosed. In embodiments, the radiation curable phase change gel marking material is an ultraviolet curable phase gel ink or an electron beam radiation curable phase change gel ink. In embodiments herein, radiation curable phase change gel inks are provided as phase change ink marking materials used to prepare digital dams having a desired pattern. The dams are then filled with conductive material and annealed to form thick conductive metallic features, electronic circuitry, and electronic devices, including, but not limited to, radio frequency identification (RFID) tags. Advantages include circumventing the previous need to print conductive ink as a thick film and avoiding the waste and environmental issues involved with etching processes. Further, the radiation curable phase change gel ink marking materials have wide substrate latitude which allows the phase change ink digital dam pattern to be printed on any substrate that can withstand the subsequent annealing process. In addition, the present disclosure provides a system and method for preparation of conductive structures in one pass.

In embodiments herein, the radiation curable phase change gel marking materials are comprised of an optional colorant, radiation curable monomers, prepolymers, and/or oligomers, a photoinitiator package, a reactive wax, and a gellant. Pigments or other functional particles may be optionally included depending on the desired application. The rheological properties of the radiation curable phase change marking materials can be tuned to achieve robust jetting at elevated temperatures (for example, in embodiments, about 85 °C) and a degree of mechanical stability (for example, in embodiments, about 10⁵ to about 10⁶ centipoise) at ambient substrate temperatures (i.e. room temperature). The increase in viscosity to from about 10⁵ to from about 10⁶ centipoise allows the digital dam patterned structure to be built up. Before curing, the structures may have a consistency resembling tooth paste and can be altered by touch. After curing, the structures are quite robust. The gel nature of the radiation curable phase change gel marking materials at room temperature prevents spread or migration of the printed droplet and allows for facile build-up of the digital dam patterned structures. Due to the radiation curable nature of this material, the printed object can be cured by any suitable or desired method, such as by exposure to ultraviolet radiation, thermal radiation, or electron beam radiation at any point in the fabrication process resulting in robust patterned features with a high degree of mechanical strength. In specific embodiments herein, if more than one printing pass is employed, the radiation curable phase change gel marking materials herein can be cured after completion of each separate printing pass used to form the digital dam if desired. Alternately, in the interest of time, the inks can be cured upon completion of all printing passes.

In embodiments, the method herein comprises printing one pass or a printing a number of successive passes of the radiation curable phase change gel marking material to form digital dams having a selected pattern. The dam pattern template can be prepared using computer software and the printheads programmed to print along the x axis and y axis in one or more printing passes. In embodiments, the pattern of fillable channels (or digital dams) is created using from about one to about five printing passes. In another embodiment, the pattern of fillable channels is created using one printing pass. In embodiments herein, patterns of virtually any design can be created, from a micro-sized scale to a macro-sized scale and can include simple patterns to patterns having complex geometries. The radiation curable phase change gel ink jet marking materials and method herein further advantageously provide a noncontact, additive process (as opposed to subtractive process such as etching) providing the built-in ability to deliver metered amounts of the present ink materials to a precise location in time and space.

In specific embodiments, the phase change ink marking materials employed herein can comprise any suitable curable monomer or oligomer. Examples of suitable materials include radiation curable monomer compounds, such as acrylate and methacrylate monomer compounds, which are suitable for use as phase change ink carriers. Specific examples of relatively nonpolar acrylate and methacrylate monomers include (but are not limited to) isobornyl acrylate, isobornyl methacrylate, lauryl acrylate, lauryl methacrylate, isodecylacrylate, isodecylmethacrylate, caprolactone acrylate, 2-phenoxyethyl acrylate, isooctylacrylate, isooctylmethacrylate, butyl acrylate, and the like, as well as mixtures and combinations thereof. In addition, multifunctional acrylate and methacrylate monomers and oligomers can be included in the phase change ink carrier as reactive diluents and as materials that can increase the crosslink density of the cured image, thereby enhancing the toughness of the cured images. Different monomer and oligomers can also be added to tune the plasticity or elasticity of the cured objects. Examples of suitable multifunctional acrylate and methacrylate monomers and oligomers include (but are not limited to) pentaerythritol tetraacrylate, pentaerythritol tetramethacrylate, 1,2-ethylene glycol diacrylate, 1,2-ethylene glycol dimethacrylate, 1,6-hexanediol diacrylate, 1,6-hexanediol dimethacrylate, 1,12-dodecanol diacrylate, 1,12-dodecanol dimethacrylate, tris(2-hydroxy ethyl) isocyanurate triacrylate, propoxylated neopentyl glycol diacrylate (available from Sartomer Co. Inc. as SR 9003), hexanediol diacrylate, tripropylene glycol diacrylate, dipropylene glycol diacrylate, amine modified polyether acrylates (available as PO 83 F, LR 8869, and/or LR 8889 (all available from BASF Corporation), trimethylolpropane triacrylate, glycerol propoxylate triacrylate, dipentaerythritol pentaacrylate, dipentaerythritol hexaacrylate, ethoxylated pentaerythritol tetraacrylate (available from Sartomer Co. Inc. as SR 494), and the like, as well as mixtures and combinations thereof. When a reactive diluent is added to the ink carrier material, the reactive diluent is added in any desired or effective amount, in one embodiment at least about 1 percent by weight of the carrier, and in another embodiment at least about 35 percent by weight of the carrier, and in one embodiment no more than about 80 percent by weight of the carrier, and in another embodiment no more than about 70 percent by weight of the carrier, although the amount of diluent can be outside of these ranges.

In embodiments, the phase change ink marking materials contain at least one compound that can exhibit gel-like behavior in that it undergoes a relatively sharp increase in viscosity over a relatively narrow temperature range when dissolved in a liquid such as those compounds that behave as curable monomers when exposed to radiation such as ultraviolet light. One example of such a liquid curable monomer is a propoxylated neopentyl glycol diacrylate such as SR9003®, commercially available from Sartomer Co. Inc.

In one embodiment, some compounds as disclosed herein undergo a change in viscosity of at least about 10³ centipoise, in another embodiment at least about 10⁵ centipoise, and in yet another embodiment at least about 10⁶ centipoise over a temperature range of in one embodiment at least about 30°C, in another embodiment at least about 10°C, and in yet another embodiment at least about 5°C, although the viscosity change and temperature range can be outside of these ranges, and compounds that do not undergo changes within these ranges are also included herein.

At least some embodiments of the compounds disclosed herein can form a semi-solid gel at a first temperature. For example, when the compound is incorporated into a phase change ink, this temperature is below the specific temperature at which the ink is jetted. The semi-solid gel phase is a physical gel that exists as a dynamic equilibrium comprising one or more solid gellant molecules and a liquid solvent. The semi-solid gel phase is a dynamic networked assembly of molecular components held together by noncovalent interactions such as hydrogen bonding, Van der Waals interactions, aromatic non-bonding interactions, ionic or coordination bonding, London dispersion forces, or the like, which, upon stimulation by physical forces, such as temperature, mechanical agitation, or the like, or chemical forces, such as pH, ionic strength, or the like, can undergo reversible transitions from liquid to semi-solid state at the macroscopic level. The solutions containing the gellant molecules exhibit a thermally reversible transition between the semi-solid gel state and the liquid state when the temperature is varied above or below the gel point of the solution. This reversible cycle of transitioning between semi-solid gel phase and liquid phase can be repeated many times in the solution formulation.

In specific embodiments, the ink vehicles disclosed herein can comprise any suitable photoinitiator. Examples of specific initiators include, but are not limited to, Irgacure® 127, Irgacure® 379, and Irgacure® 819, all commercially available from Ciba Specialty Chemicals, among others. Further examples of suitable initiators include (but are not limited to) benzophenones, benzyl ketones, monomeric hydroxyl ketones, polymeric hydroxyl ketones, α-alkoxy benzyl ketones, α-amino ketones, acyl phosphine oxides, metallocenes, benzoin ethers, benzil ketals, α-hydroxyalkylphenones, α-aminoalkylphenones, acylphosphine photoinitiators sold under the trade designations of Irgacure® and Darocur® available from Ciba Specialty Chemicals, and the like. Specific examples include 1-hydroxy-cyclohexylphenylketone, benzophenone, 2-benzyl-2-(dimethylamino)-1-(4-(4-morphorlinyl)phenyl)-1-butanone, 2-methyl-1-(4-methylthio)phenyl-2-(4-morphorlinyl)-1-propanone, diphenyl-(2,4,6-trimethylbenzoyl) phosphine oxide, phenyl bis(2,4,6-trimethylbenzoyl) phosphine oxide, benzyl-dimethylketal, isopropylthioxanthone, 2,4,6-trimethylbenzoyldiphenylphosphine oxide (available as BASF LUCIRIN® TPO), 2,4,6-trimethylbenzoylethoxyphenylphosphine oxide (available as BASF LUCIRIN® TPO-L), bis(2,4,6-trimethylbenzoyl)-phenyl-phosphine oxide (available as Ciba IRGACURE® 819) and other acyl phosphines, 2-methyl-1-(4-methylthio)phenyl-2-(4-morphorlinyl)-1-propanone (available as Ciba IRGACURE® 907) and 1-(4-(2-hydroxyethoxy)phenyl)-2-hydroxy-2-methylpropan-1-one (available as Ciba IRGACURE® 2959), 2-benzyl 2-dimethylamino 1-(4-morpholinophenyl) butanone-1 (available as Ciba IRGACURE® 369), 2-hydroxy-1-(4-(4-(2-hydroxy-2-methylpropionyl)-benzyl)-phenyl)-2-methylpropan-1-one (available as Ciba IRGACURE® 127), 2-dimethylamino-2-(4-methylbenzyl)-1-(4-morpholin-4-ylphenyl)-butanone (available as Ciba IRGACURE® 379), titanocenes, isopropylthioxanthone, 1-hydroxy-cyclohexylphenylketone, benzophenone, 2,4,6-trimethylbenzophenone, 4-methylbenzophenone, diphenyl-(2,4,6-trimethylbenzoyl) phosphine oxide, 2,4,6-trimethylbenzoylphenylphosphinic acid ethyl ester, oligo(2-hydroxy-2-methyl-1-(4-(1-methylvinyl)phenyl) propanone), 2-hydroxy-2-methyl-1-phenyl-1-propanone, benzyl-dimethylketal, and the like, as well as mixtures thereof.

Optionally, the phase change inks can also contain an amine synergist, which are co-initiators which can donate a hydrogen atom to a photoinitiator and thereby form a radical species that initiates polymerization, and can also consume dissolved oxygen, which inhibits free-radical polymerization, thereby increasing the speed of polymerization. Examples of suitable amine synergists include (but are not limited to) ethyl-4-dimethylaminobenzoate, 2-ethylhexyl-4-dimethylaminobenzoate, and the like, as well as mixtures thereof.

Initiators for inks disclosed herein can absorb radiation at any desired or effective wavelength, in one embodiment at least about 200 nanometers, and in one embodiment no more than about 560 nanometers, and in another embodiment no more than about 420 nanometers, although the wavelength can be outside of these ranges.

Optionally, the photoinitiator is present in the phase change ink in any desired or effective amount, in one embodiment at least about 0.5 percent by weight of the ink composition, and in another embodiment at least about 1 percent by weight of the ink composition, and in one embodiment no more than about 15 percent by weight of the ink composition, and in another embodiment no more than about 10 percent by weight of the ink composition, although the amount can be outside of these ranges.

Any suitable reactive wax can be used for the phase change ink vehicles disclosed herein. In embodiments, the reactive wax comprises a curable wax component that is miscible with the other components and that will polymerize with the curable monomer to form a polymer. Inclusion of the wax promotes an increase in viscosity of the ink as it cools from the jetting temperature.

Suitable examples of waxes include, but are not limited to, those that are functionalized with curable groups. The curable groups may include, but are not limited to, acrylate, methacrylate, alkene, allylic ether, epoxide and oxetane. These waxes can be synthesized by the reaction of a wax equipped with a transformable functional group, such as carboxylic acid or hydroxyl.

Suitable examples of hydroxyl-terminated polyethylene waxes that may be functionalized with a curable group include, but are not limited to, mixtures of carbon chains with the structure CH₃-(CH₂)ₙ-CH₂OH, where there is a mixture of chain lengths, n, where the average chain length is in selected embodiments in the range of about 16 to about 50, and linear low molecular weight polyethylene, of similar average chain length. Suitable examples of such waxes include, but are not limited to, UNILIN® 350, UNFLIN® 425, UNILIN® 550 and UNILIN® 700 with Mn approximately equal to 375, 460, 550 and 700 g/mol, respectively. All of these waxes are commercially available from Baker-Petrolite. Guerbet alcohols, characterized as 2,2-dialkyl-1-ethanols, are also suitable compounds. Specific embodiments of Guerbet alcohols include those containing 16 to 36 carbons, many of which are commercially available from Jarchem Industries Inc., Newark, NJ. In embodiments, PRIPOL® 2033 is selected, PRIPOL® 2033 being a C-36 dimer diol mixture including isomers of the formula

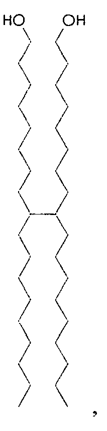

as well as other branched isomers which may include unsaturations and cyclic groups, available from Uniqema, New Castle, DE. Further information on C36 dimer diols of this type is disclosed in, for example, "Dimer Acids," Kirk-Othmer Encyclopedia of Chemical Technology, Vol. 8, 4th Ed. (1992), pp. 223 to 237,. These alcohols can be reacted with carboxylic acids equipped with UV curable moieties to form reactive esters. Examples of these acids include, but are not limited to, acrylic and methacrylic acids, available from Sigma-Aldrich Co. Specific curable monomers include acrylates of UNILIN® 350, UNILIN® 425, UNILIN® 550 and UNILIN® 700.

Suitable examples of carboxylic acid-terminated polyethylene waxes that may be functionalized with a curable group include, but are not limited to, mixtures of carbon chains with the structure CH₃-(CH₂)ₙ-COOH, where there is a mixture of chain lengths, n, where the average chain length is in selected embodiments in the range of about 16 to about 50, and linear low molecular weight polyethylene, of similar average chain length. Suitable examples of such waxes include, but are not limited to, UNICID® 350, UNICID® 425, UNICID® 550 and UNICID® 700 with Mn equal to approximately 390, 475, 565 and 720 g/mol, respectively. Other suitable waxes have a structure CH₃-(CH₂)ₙ-COOH, such as hexadecanoic or palmitic acid with n=14, heptadecanoic or margaric or daturic acid with n=15, octadecanoic or stearic acid with n=16, eicosanoic or arachidic acid with n=18, docosanoic or behenic acid with n=20, tetracosanoic or lignoceric acid with n=22, hexacosanoic or cerotic acid with n=24, heptacosanoic or carboceric acid with n=25, octacosanoic or montanic acid with n=26, triacontanoic or melissic acid with n=28, dotriacontanoic or lacceroic acid with n=30, tritriacontanoic or ceromelissic or psyllic acid, with n=31, tetratriacontanoic or geddic acid with n=32, pentatriacontanoic or ceroplastic acid with n=33. Guerbet acids, characterized as 2,2-dialkyl ethanoic acids, are also suitable compounds. Selected Guerbet acids include those containing 16 to 36 carbons, many of which are commercially available from Jarchem Industries Inc., Newark, NJ. PRIPOL® 1009 (C-36 dimer acid mixture including isomers of the formula

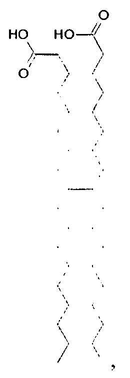

as well as other branched isomers which may include unsaturations and cyclic groups, available from Uniqema, New Castle, DE; further information on C36 dimer acids of this type is disclosed in, for example, "Dimer Acids," Kirk-Othmer Encyclopedia of Chemical Technology, Vol. 8, 4th Ed. (1992), pp. 223 to 237, can also be used. These carboxylic acids can be reacted with alcohols equipped with UV curable moieties to form reactive esters. Examples of these alcohols include, but are not limited to, 2-allyloxyethanol from Sigma-Aldrich Co.;

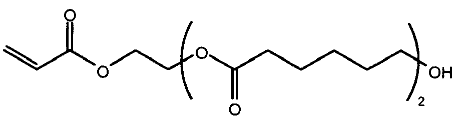

SR495B from Sartomer Company, Inc.;

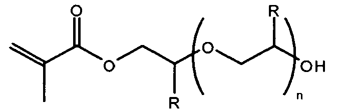

CD572 (R = H, n = 10) and SR604 (R = Me, n = 4) from Sartomer Company, Inc.

In embodiments, the optional curable wax is included in the ink in an amount of from, for example, about 1 to about 25% by weight of the ink, or from about 2 to about 20% by weight of the ink, or from about 2.5 to about 15% by weight of the ink, although the amounts can be outside of these ranges.

The curable monomer or prepolymer and curable wax together can form more than about 50% by weight of the ink, or at least 70% by weight of the ink, or at least 80% by weight of the ink, although not limited.

Any suitable gellant can be used for the ink vehicles disclosed herein. In embodiments, a gellant such as described in U. S. Patent Publication 20070120910, published May 31, 2007, entitled "Phase Change Inks Containing Photoinitiator With Phase Change Properties and Gellant Affinity," with the named inventors Peter G. Odell, Eniko Toma, and Jennifer L. Belelie, can be used, wherein the gellant is a compound of the formula

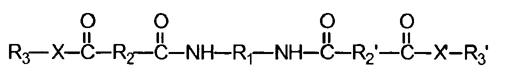

wherein R₁ is:
(i) an alkylene group (wherein an alkylene group is defined as a divalent aliphatic group or alkyl group, including linear and branched, saturated and unsaturated, cyclic and acyclic, and substituted and unsubstituted alkylene groups, and wherein heteroatoms, such as oxygen, nitrogen, sulfur, silicon, phosphorus, boron, and the like either may or may not be present in the alkylene group), in one embodiment with at least 1 carbon atom, and in one embodiment with no more than about 12 carbon atoms, in another embodiment with no more than about 4 carbon atoms, and in yet another embodiment with no more than about 2 carbon atoms, although the number of carbon atoms can be outside of these ranges,
(ii) an arylene group (wherein an arylene group is defined as a divalent aromatic group or aryl group, including substituted and unsubstituted arylene groups, and wherein heteroatoms, such as oxygen, nitrogen, sulfur, silicon, phosphorus, boron, and the like either may or may not be present in the arylene group), in one embodiment with at least about 5 carbon atoms, and in another embodiment with at least about 6 carbon atoms, and in one embodiment with no more than about 14 carbon atoms, in another embodiment with no more than about 10 carbon atoms, and in yet another embodiment with no more than about 6 carbon atoms, although the number of carbon atoms can be outside of these ranges,
(iii) an arylalkylene group (wherein an arylalkylene group is defined as a divalent arylalkyl group, including substituted and unsubstituted arylalkylene groups, wherein the alkyl portion of the arylalkylene group can be linear or branched, saturated or unsaturated, and cyclic or acyclic, and wherein heteroatoms, such as oxygen, nitrogen, sulfur, silicon, phosphorus, boron, and the like either may or may not be present in either the aryl or the alkyl portion of the arylalkylene group), in one embodiment with at least about 6 carbon atoms, and in another embodiment with at least about 7 carbon atoms, and in one embodiment with no more than about 32 carbon atoms, in another embodiment with no more than about 22 carbon atoms, and in yet another embodiment with no more than about 7 carbon atoms, although the number of carbon atoms can be outside of these ranges, or
(iv) an alkylarylene group (wherein an alkylarylene group is defined as a divalent alkylaryl group, including substituted and unsubstituted alkylarylene groups, wherein the alkyl portion of the alkylarylene group can be linear or branched, saturated or unsaturated, and cyclic or acyclic, and wherein heteroatoms, such as oxygen, nitrogen, sulfur, silicon, phosphorus, boron, and the like either may or may not be present in either the aryl or the alkyl portion of the alkylarylene group), in one embodiment with at least about 6 carbon atoms, and in another embodiment with at least about 7 carbon atoms, and in one embodiment with no more than about 32 carbon atoms, in another embodiment with no more than about 22 carbon atoms, and in yet another embodiment with no more than about 7 carbon atoms, although the number of carbon atoms can be outside of these ranges, wherein the substituents on the substituted alkylene, arylene, arylalkylene, and alkylarylene groups can be (but are not limited to) halogen atoms, cyano groups, pyridine groups, pyridinium groups, ether groups, aldehyde groups, ketone groups, ester groups, amide groups, carbonyl groups, thiocarbonyl groups, sulfide groups, nitro groups, nitroso groups, acyl groups, azo groups, urethane groups, urea groups, mixtures thereof, and the like, wherein two or more substituents can be joined together to form a ring;

R₂ and R₂' each, independently of the other, are:
(i) alkylene groups (wherein an alkylene group is defined as a divalent aliphatic group or alkyl group, including linear and branched, saturated and unsaturated, cyclic and acyclic, and substituted and unsubstituted alkylene groups, and wherein heteroatoms, such as oxygen, nitrogen, sulfur, silicon, phosphorus, boron, and the like either may or may not be present in the alkylene group), in one embodiment with at least 1 carbon atom, and in one embodiment with no more than about 54 carbon atoms, and in another embodiment with no more than about 36 carbon atoms, although the number of carbon atoms can be outside of these ranges,
(ii) arylene groups (wherein an arylene group is defined as a divalent aromatic group or aryl group, including substituted and unsubstituted arylene groups, and wherein heteroatoms, such as oxygen, nitrogen, sulfur, silicon, phosphorus, boron, and the like either may or may not be present in the arylene group), in one embodiment with at least about 5 carbon atoms, and in another embodiment with at least about 6 carbon atoms, and in one embodiment with no more than about 14 carbon atoms, in another embodiment with no more than about 10 carbon atoms, and in yet another embodiment with no more than about 7 carbon atoms, although the number of carbon atoms can be outside of these ranges,
(iii) arylalkylene groups (wherein an arylalkylene group is defined as a divalent arylalkyl group, including substituted and unsubstituted arylalkylene groups, wherein the alkyl portion of the arylalkylene group can be linear or branched, saturated or unsaturated, and cyclic or acyclic, and wherein heteroatoms, such as oxygen, nitrogen, sulfur, silicon, phosphorus, boron, and the like either may or may not be present in either the aryl or the alkyl portion of the arylalkylene group), in one embodiment with at least about 6 carbon atoms, and in another embodiment with at least about 7 carbon atoms, and in one embodiment with no more than about 32 carbon atoms, in another embodiment with no more than about 22 carbon atoms, and in yet another embodiment with no more than about 8 carbon atoms, although the number of carbon atoms can be outside of these ranges, or
(iv) alkylarylene groups (wherein an alkylarylene group is defined as a divalent alkylaryl group, including substituted and unsubstituted alkylarylene groups, wherein the alkyl portion of the alkylarylene group can be linear or branched, saturated or unsaturated, and cyclic or acyclic, and wherein heteroatoms, such as oxygen, nitrogen, sulfur, silicon, phosphorus, boron, and the like either may or may not be present in either the aryl or the alkyl portion of the alkylarylene group), in one embodiment with at least about 6 carbon atoms, and in another embodiment with at least about 7 carbon atoms, and in one embodiment with no more than about 32 carbon atoms, in another embodiment with no more than about 22 carbon atoms, and in yet another embodiment with no more than about 7 carbon atoms, although the number of carbon atoms can be outside of these ranges, wherein the substituents on the substituted alkylene, arylene, arylalkylene, and alkylarylene groups can be (but are not limited to) halogen atoms, cyano groups, ether groups, aldehyde groups, ketone groups, ester groups, amide groups, carbonyl groups, thiocarbonyl groups, phosphine groups, phosphonium groups, phosphate groups, nitrile groups, mercapto groups, nitro groups, nitroso groups, acyl groups, acid anhydride groups, azide groups, azo groups, cyanato groups, urethane groups, urea groups, mixtures thereof, and the like, wherein two or more substituents can be joined together to form a ring;

R₃ and R₃' each, independently of the other, are either:
(a) photoinitiating groups, such as groups derived from 1-(4-(2-hydroxyethoxy)phenyl)-2-hydroxy-2-methylpropan-1-one, of the formula 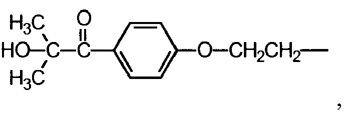 groups derived from 1-hydroxycyclohexylphenylketone, of the formula 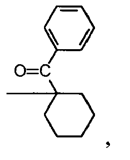 groups derived from 2-hydroxy-2-methyl-1-phenylpropan-1-one, of the formula 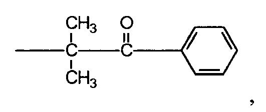 groups derived from *N,N-*dimethylethanolamine or *N,N*-dimethylethylenediamine, of the formula 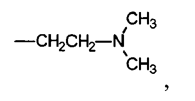 or the like, or:
(b) a group which is:
   (i) an alkyl group (including linear and branched, saturated and unsaturated, cyclic and acyclic, and substituted and unsubstituted alkyl groups, and wherein heteroatoms, such as oxygen, nitrogen, sulfur, silicon, phosphorus, boron, and the like either may or may not be present in the alkyl group), in one embodiment with at least about 2 carbon atoms, in another embodiment with at least about 3 carbon atoms, and in yet another embodiment with at least about 4 carbon atoms, and in one embodiment with no more than about 100 carbon atoms, in another embodiment with no more than about 60 carbon atoms, and in yet another embodiment with no more than about 30 carbon atoms, although the number of carbon atoms can be outside of these ranges,
   (ii) an aryl group (including substituted and unsubstituted aryl groups, and wherein heteroatoms, such as oxygen, nitrogen, sulfur, silicon, phosphorus, boron, and the like either may or may not be present in the aryl group), in one embodiment with at least about 5 carbon atoms, and in another embodiment with at least about 6 carbon atoms, and in one embodiment with no more than about 100 carbon atoms, in another embodiment with no more than about 60 carbon atoms, and in yet another embodiment with no more than about 30 carbon atoms, although the number of carbon atoms can be outside of these ranges, such as phenyl or the like,
   (iii) an arylalkyl group (including substituted and unsubstituted arylalkyl groups, wherein the alkyl portion of the arylalkyl group can be linear or branched, saturated or unsaturated, and cyclic or acyclic, and wherein heteroatoms, such as oxygen, nitrogen, sulfur, silicon, phosphorus, boron, and the like either may or may not be present in either the aryl or the alkyl portion of the arylalkyl group), in one embodiment with at least about 6 carbon atoms, and in another embodiment with at least about 7 carbon atoms, and in one embodiment with no more than about 100 carbon atoms, in another embodiment with no more than about 60 carbon atoms, and in yet another embodiment with no more than about 30 carbon atoms, although the number of carbon atoms can be outside of these ranges, such as benzyl or the like, or
   (iv) an alkylaryl group (including substituted and unsubstituted alkylaryl groups, wherein the alkyl portion of the alkylaryl group can be linear or branched, saturated or unsaturated, and cyclic or acyclic, and wherein heteroatoms, such as oxygen, nitrogen, sulfur, silicon, phosphorus, boron, and the like either may or may not be present in either the aryl or the alkyl portion of the alkylaryl group), in one embodiment with at least about 6 carbon atoms, and in another embodiment with at least about 7 carbon atoms, and in one embodiment with no more than about 100 carbon atoms, in another embodiment with no more than about 60 carbon atoms, and in yet another embodiment with no more than about 30 carbon atoms, although the number of carbon atoms can be outside of these ranges, such as tolyl or the like, wherein the substituents on the substituted alkyl, arylalkyl, and alkylaryl groups can be (but are not limited to) halogen atoms, ether groups, aldehyde groups, ketone groups, ester groups, amide groups, carbonyl groups, thiocarbonyl groups, sulfide groups, phosphine groups, phosphonium groups, phosphate groups, nitrile groups, mercapto groups, nitro groups, nitroso groups, acyl groups, acid anhydride groups, azide groups, azo groups, cyanato groups, isocyanato groups, thiocyanato groups, isothiocyanato groups, carboxylate groups, carboxylic acid groups, urethane groups, urea groups, mixtures thereof, and the like, wherein two or more substituents can be joined together to form a ring;

provided that at least one of R₃ and R₃' is a photoinitiating group;

and X and X' each, independently of the other, is an oxygen atom or a group of the formula -NR₄-, wherein R₄ is:
(i) a hydrogen atom;
(ii) an alkyl group, including linear and branched, saturated and unsaturated, cyclic and acyclic, and substituted and unsubstituted alkyl groups, and wherein heteroatoms either may or may not be present in the alkyl group, in one embodiment with at least 1 carbon atom, and in one embodiment with no more than about 100 carbon atoms, in another embodiment with no more than about 60 carbon atoms, and in yet another embodiment with no more than about 30 carbon atoms, although the number of carbon atoms can be outside of these ranges,
(iii) an aryl group, including substituted and unsubstituted aryl groups, and wherein heteroatoms either may or may not be present in the aryl group, in one embodiment with at least about 5 carbon atoms, and in another embodiment with at least about 6 carbon atoms, and in one embodiment with no more than about 100 carbon atoms, in another embodiment with no more than about 60 carbon atoms, and in yet another embodiment with no more than about 30 carbon atoms, although the number of carbon atoms can be outside of these ranges,
(iv) an arylalkyl group, including substituted and unsubstituted arylalkyl groups, wherein the alkyl portion of the arylalkyl group can be linear or branched, saturated or unsaturated, and cyclic or acyclic, and wherein heteroatoms either may or may not be present in either the aryl or the alkyl portion of the arylalkyl group, in one embodiment with at least about 6 carbon atoms, and in another embodiment with at least about 7 carbon atoms, and in one embodiment with no more than about 100 carbon atoms, in another embodiment with no more than about 60 carbon atoms, and in yet another embodiment with no more than about 30 carbon atoms, although the number of carbon atoms can be outside of these ranges, or
(v) an alkylaryl group, including substituted and unsubstituted alkylaryl groups, wherein the alkyl portion of the alkylaryl group can be linear or branched, saturated or unsaturated, and cyclic or acyclic, and wherein heteroatoms either may or may not be present in either the aryl or the alkyl portion of the alkylaryl group, in one embodiment with at least about 6 carbon atoms, and in another embodiment with at least about 7 carbon atoms, and in one embodiment with no more than about 100 carbon atoms, in another embodiment with no more than about 60 carbon atoms, and in yet another embodiment with no more than about 30 carbon atoms, although the number of carbon atoms can be outside of these ranges, wherein the substituents on the substituted alkyl, aryl, arylalkyl, and alkylaryl groups can be (but are not limited to) halogen atoms, ether groups, aldehyde groups, ketone groups, ester groups, amide groups, carbonyl groups, thiocarbonyl groups, sulfate groups, sulfonate groups, sulfonic acid groups, sulfide groups, sulfoxide groups, phosphine groups, phosphonium groups, phosphate groups, nitrile groups, mercapto groups, nitro groups, nitroso groups, sulfone groups, acyl groups, acid anhydride groups, azide groups, azo groups, cyanato groups, isocyanato groups, thiocyanato groups, isothiocyanato groups, carboxylate groups, carboxylic acid groups, urethane groups, urea groups, mixtures thereof, and the like, wherein two or more substituents can be joined together to form a ring.

In one specific embodiment, R₂ and R₂' are the same as each other; in another specific embodiment, R₂ and R₂' are different from each other. In one specific embodiment, R₃ and R₃' are the same as each other; in another specific embodiment, R₃ and R₃' are different from each other.

In one specific embodiment, R₂ and R₂' are each groups of the formula -C₃₄H₅₆₊ₐ- and are branched alkylene groups which may include unsaturations and cyclic groups, wherein a is an integer of 0, 1, 2, 3, 4, 5, 6, 7, 8, 9, 10, 11, or 12, including (but not limited to) isomers of the formula

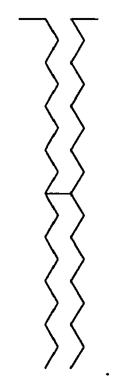

In one specific embodiment, R₁ is an ethylene (-CH₂CH₂-) group.

In one specific embodiment, R₃ and R₃' are both

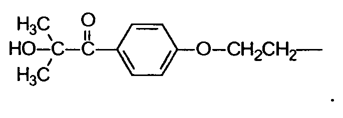

In one specific embodiment, the compound is of the formula

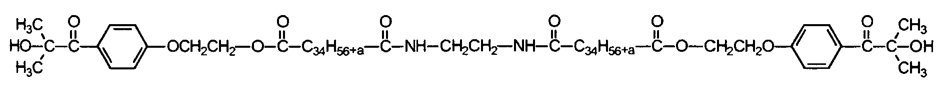

wherein -C₃₄H₅₆₊ₐ- represents a branched alkylene group which may include unsaturations and cyclic groups, wherein a is an integer of 0, 1, 2, 3, 4, 5, 6, 7, 8, 9, 10, 11, or 12, including (but not limited to) isomers of the formula

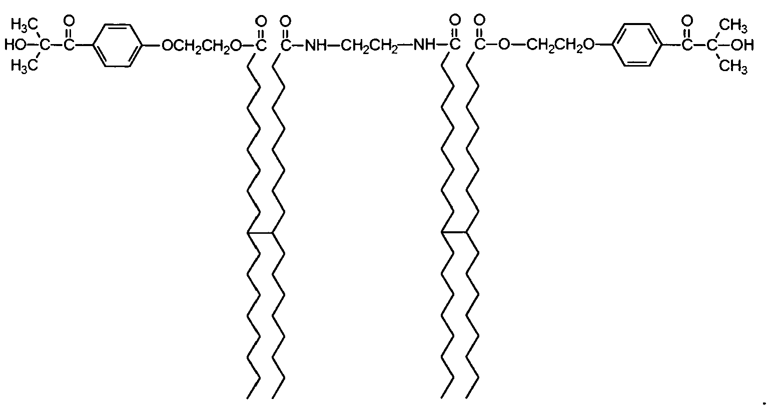

Additional specific examples of compounds of this formula include those of the formula

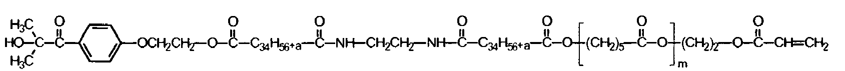

wherein -C₃₄H₅₆₊ₐ- represents a branched alkylene group which may include unsaturations and cyclic groups, wherein a is an integer of 0, 1, 2, 3, 4, 5, 6, 7, 8, 9, 10, 11, or 12 and wherein m is an integer, including but not limited to embodiments wherein m is 2, including (but not limited to) isomers of the formula

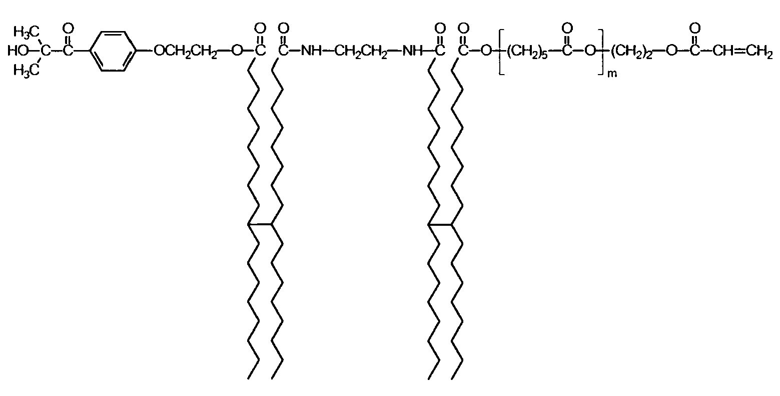

those of the formula

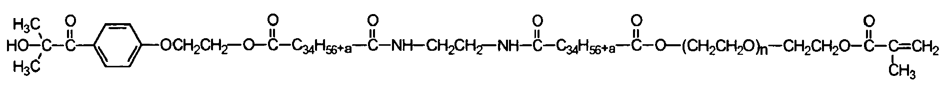

wherein -C₃₄H₅₆₊ₐ- represents a branched alkylene group which may include unsaturations and cyclic groups, wherein a is an integer of 0, 1, 2, 3, 4, 5, 6, 7, 8, 9, 10, 11, or 12 and wherein n is an integer, including but not limited to embodiments wherein n is 2 and wherein n is 5, including (but not limited to) isomers of the formula

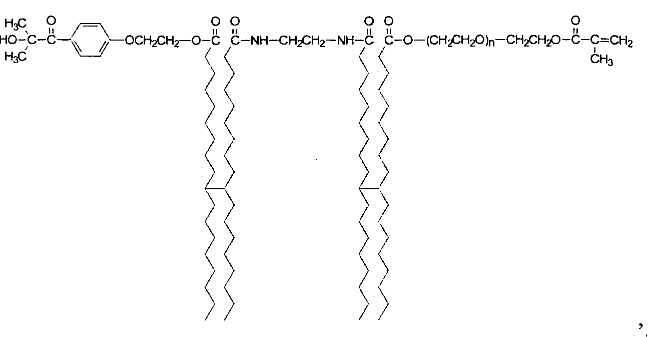

those of the formula

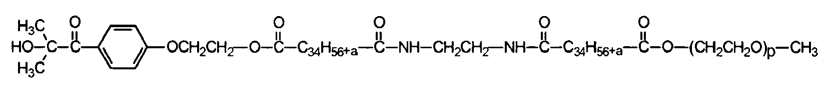

wherein -C₃₄H₅₆₊ₐ- represents a branched alkylene group which may include unsaturations and cyclic groups, wherein a is an integer of 0, 1, 2, 3, 4, 5, 6, 7, 8, 9, 10, 11, or 12 and wherein p is an integer, including but not limited to embodiments wherein p is 2 and wherein p is 3, including (but not limited to) isomers of the formula

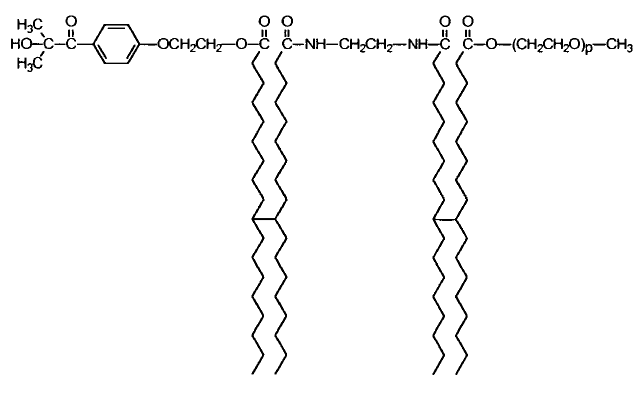

those of the formula

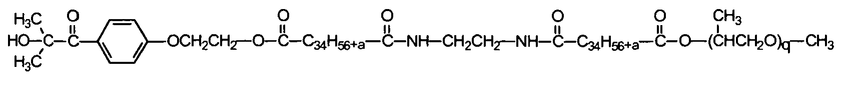

wherein -C₃₄H₅₆₊ₐ- represents a branched alkylene group which may include unsaturations and cyclic groups, wherein a is an integer of 0, 1, 2, 3, 4, 5, 6, 7, 8, 9, 10, 11, or 12 and wherein q is an integer, including but not limited to embodiments wherein q is 2 and wherein q is 3, including (but not limited to) isomers of the formula

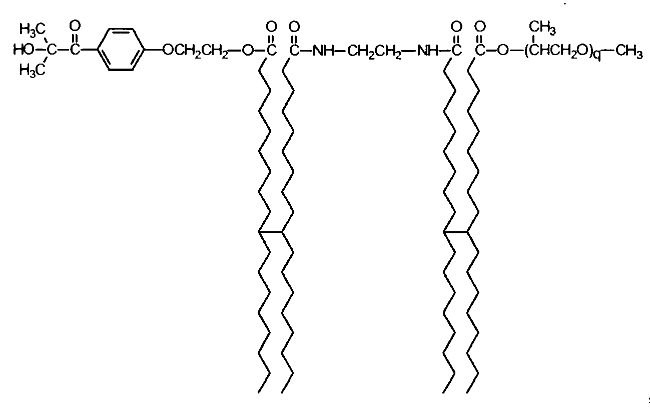

those of the formula

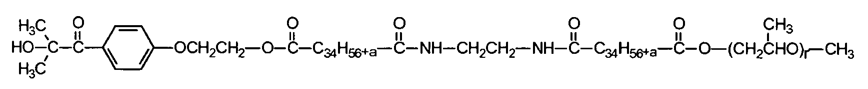

wherein -C₃₄H₅₆₊ₐ- represents a branched alkylene group which may include unsaturations and cyclic groups, wherein a is an integer of 0, 1, 2, 3, 4, 5, 6, 7, 8, 9, 10, 11, or 12 and wherein r is an integer, including but not limited to embodiments wherein r is 2 and wherein r is 3, including (but not limited to) isomers of the formula

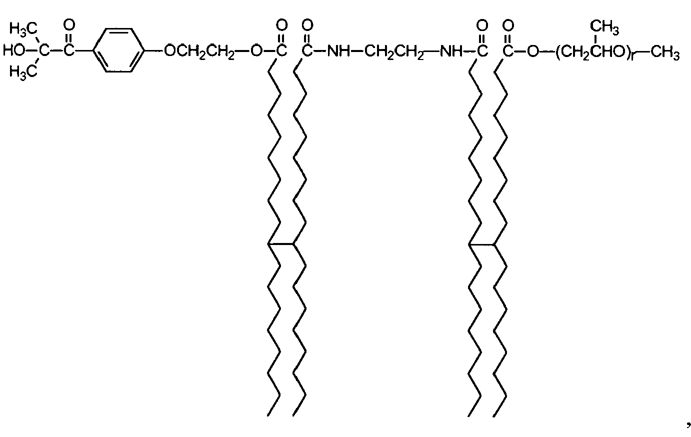

and the like, as well as mixtures thereof.

In embodiments, gellants herein can comprise materials disclosed U. S. Patent Publication 20070123606, published May 31, 2007, entitled "Phase Change Inks Containing Curable Amide Gellant Compounds," with the named inventors Eniko Toma, Jennifer L. Belelie, and Peter G. Odell, including a compound of the formula

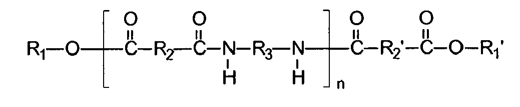

wherein R₁ and R₁' each, independently of the other, is an alkyl group having at least one ethylenic unsaturation, an arylalkyl group having at least one ethylenic unsaturation, or an alkylaryl group having at least one ethylenic unsaturation, R₂, R₂', and R₃ each, independently of the others, are alkylene groups, arylene groups, arylalkylene groups, or alkylarylene groups, and n is an integer representing the number of repeat amide units and is at least 1.

The gellant compounds as disclosed herein can be prepared by any desired or effective method.

For example, in embodiments, gellants can be prepared as described in U. S. Patent 7,259,275, entitled "Method for Preparing Curable Amide Gellant Compounds," with the named inventors Jennifer L. Belelie, Adela Goredema, Peter G. Odell, and Eniko Toma, which describes a process for preparing a compound of the formula

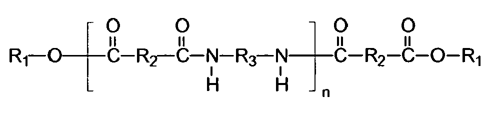

wherein R₁ is an alkyl group having at least one ethylenic unsaturation, an arylalkyl group having at least one ethylenic unsaturation, or an alkylaryl group having at least one ethylenic unsaturation, R₂ and R₃ each, independently of the others, are alkylene groups, arylene groups, arylalkylene groups, or alkylarylene groups, and n is an integer representing the number of repeat amide units and is at least 1, said process comprising: (a) reacting a diacid of the formula

HOOC-R₂-COOH

with a diamine of the formula

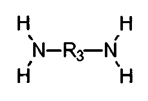

in the absence of a solvent while removing water from the reaction mixture to form an acid-terminated oligoamide intermediate; and (b) reacting the acid-terminated oligoamide intermediate with a monoalcohol of the formula

R₁-OH

in the presence of a coupling agent and a catalyst to form the product.

Optionally, a colorant is included in the in the radiation curable phase change gel ink marking materials in any desired amount, for example from about 0.5 to about 75% by weight of the marking material, for example from about 1 to about 50% or from about 1 to about 25%, by weight of the marking material.

Any suitable colorant can be used in embodiments herein, including dyes, pigments, or combinations thereof. As colorants, examples may include any dye or pigment capable of being dispersed or dissolved in the vehicle. Examples of suitable pigments include, for example, Paliogen Violet 5100 (BASF); Paliogen Violet 5890 (BASF); Heliogen Green L8730 (BASF); Lithol Scarlet D3700 (BASF); SUNFAST® Blue 15:4 (Sun Chemical 249-0592); HOSTAPERM Blue B2G-D (Clariant); Permanent Red P-F7RK; HOSTAPERM Violet BL (Clariant); Lithol Scarlet 4440 (BASF); Bon Red C (Dominion Color Company); Oracet Pink RF (Ciba); Paliogen Red 3871 K (BASF); SUNFAST ® Blue 15:3 (Sun Chemical 249-1284); Paliogen Red 3340 (BASF); SUNFAST ® Carbazole Violet 23 (Sun Chemical 246-1670); Lithol Fast Scarlet L4300 (BASF); Sunbrite Yellow 17 (Sun Chemical 275-0023); Heliogen Blue L6900, L7020 (BASF); Sunbrite Yellow 74 (Sun Chemical 272-0558); SPECTRA PAC® C Orange 16 (Sun Chemical 276-3016); Heliogen Blue K6902, K6910 (BASF); SUNFAST® Magenta 122 (Sun Chemical 228-0013); Heliogen Blue D6840, D7080 (BASF); Sudan Blue OS (BASF); Neopen Blue FF4012 (BASF); PV Fast Blue B2GO1 (Clariant); Irgalite Blue BCA (Ciba); Paliogen Blue 6470 (BASF); Sudan Orange G (Aldrich); Sudan Orange 220 (BASF); Paliogen Orange 3040 (BASF); Paliogen Yellow 152, 1560 (BASF); Lithol Fast Yellow 0991 K (BASF); Paliotol Yellow 1840 (BASF); Novoperm Yellow FGL (Clariant); Lumogen Yellow D0790 (BASF); Suco-Yellow L1250 (BASF); Suco-Yellow D1355 (BASF); Suco Fast Yellow D1 355, D1 351 (BASF); Hostaperm Pink E 02 (Clariant); Hansa Brilliant Yellow 5GX03 (Clariant); Permanent Yellow GRL 02 (Clariant); Permanent Rubine L6B 05 (Clariant); Fanal Pink D4830 (BASF); Cinquasia Magenta (Du Pont), Paliogen Black L0084 (BASF); Pigment Black K801 (BASF); and carbon blacks such as REGAL 33™ (Cabot), Carbon Black 5250, Carbon Black 5750 (Columbia Chemical), mixtures thereof and the like. Examples of suitable dyes include Usharect Blue 86 (Direct Blue 86), available from Ushanti Color; Intralite Turquoise 8GL (Direct Blue 86), available from Classic Dyestuffs; Chemictive Brilliant Red 7BH (Reactive Red 4), available from Chemiequip; Levafix Black EB, available from Bayer; Reactron Red H8B (Reactive Red 31), available from Atlas Dye-Chem; D&C Red #28 (Acid Red 92), available from Warner-Jenkinson; Direct Brilliant Pink B, available from Global Colors; Acid Tartrazine, available from Metrochem Industries; Cartasol Yellow 6GF Clariant; Carta Blue 2GL, available from Clariant; and the like. Example solvent dyes include spirit soluble dyes such as Neozapon Red 492 (BASF); Orasol Red G (Ciba); Direct Brilliant Pink B (Global Colors); Aizen Spilon Red C-BH (Hodogaya Chemical); Kayanol Red 3BL (Nippon Kayaku); Spirit Fast Yellow 3G; Aizen Spilon Yellow C-GNH (Hodogaya Chemical); Cartasol Brilliant Yellow 4GF (Clariant); Pergasol Yellow CGP (Ciba); Orasol Black RLP (Ciba); Savinyl Black RLS (Clariant); Morfast Black Conc. A (Rohm and Haas); Orasol Blue GN (Ciba); Savinyl Blue GLS (Sandoz); Luxol Fast Blue MBSN (Pylam); Sevron Blue 5GMF (Classic Dyestuffs); Basacid Blue 750 (BASF), Neozapon Black X51 [C.I. Solvent Black, C.I. 12195] (BASF), Sudan Blue 670 [C.I. 61554] (BASF), Sudan Yellow 146 [C.I. 12700] (BASF), Sudan Red 462 [C.I. 260501] (BASF), mixtures thereof and the like.

The radiation curable phase change gel inks herein can also optionally contain an antioxidant. The optional antioxidants can protect the images from oxidation and can also protect the ink components from oxidation during the heating portion of the ink preparation process. Specific examples of suitable antioxidant stabilizers include (but are not limited to) NAUGARD® 524, NAUGARD® 635, NAUGARD® A, NAUGARD® I-403, and NAUGARD® 959, commercially available from Crompton Corporation, Middlebury, CT; IRGANOX® 1010 and IRGASTAB® UV 10, commercially available from Ciba Specialty Chemicals; GENORAD 16 and GENORAD 40 commercially available from Rahn AG, Zurich, Switzerland, and the like, as well as mixtures thereof. When present, the optional antioxidant is present in the ink in any desired or effective amount, in one embodiment at least about 0.01 percent by weight of the ink carrier, in another embodiment at least about 0.1 percent by weight of the ink carrier, and in yet another embodiment at least about 1 percent by weight of the ink carrier, and in one embodiment no more than about 20 percent by weight of the ink carrier, in another embodiment no more than about 5 percent by weight of the ink carrier, and in yet another embodiment no more than about 3 percent by weight of the ink carrier, although the amount can be outside of these ranges.

The radiation curable phase change gel inks can also, if desired, contain additives to take advantage of the known functionality associated with such additives. Such additives may include, for example, defoamers, slip and leveling agents, pigment dispersants, surfactants, and the like, as well as mixtures thereof. The inks can also include additional monomeric or polymeric materials as desired.

The term "curable" describes, for example, a material that may be cured via polymerization, including for example free radical routes, and/or in which polymerization is photoinitiated though use of a radiation-sensitive photoinitiator. The term "radiation-curable" refers, for example, to all forms of curing upon exposure to a radiation source, including light and heat sources and including in the presence or absence of initiators. Exemplary radiation-curing routes include, but are not limited to, curing using ultraviolet (UV) light, for example having a wavelength of 200-400 nm or more rarely visible light, optionally in the presence of photoinitiators and/or sensitizers, curing using electron-beam radiation, optionally in the absence of photoinitiators, curing using thermal curing, in the presence or absence of high-temperature thermal initiators (and which may be largely inactive at the jetting temperature), and appropriate combinations thereof.

For example, in embodiments, curing of the ink can be effected by exposure of the ink image to actinic radiation at any desired or effective wavelength, in one embodiment at least about 200 nanometers, and one embodiment no more than about 480 nanometers, although the wavelength can be outside of these ranges. Exposure to actinic radiation can be for any desired or effective period of time, in one embodiment for at least about 0.2 second, in another embodiment for at least about 1 second, and in yet another embodiment for at least about 5 seconds, and in one embodiment for no more than about 30 seconds, and in another embodiment for no more than about 15 seconds, although the exposure period can be outside of these ranges.

As used herein, the term "viscosity" refers to a complex viscosity, which is the typical measurement provided by a mechanical rheometer that is capable of subjecting a sample to a steady shear strain or a small amplitude sinusoidal deformation. In this type of instrument, the shear strain is applied by the operator to the motor and the sample deformation (torque) is measured by the transducer. Examples of such instruments are the Rheometrics Fluid Rheometer RFS3 or the ARES mechanical spectrometer, both made by Rheometrics, a division of TA Instruments. Alternatively a controlled-stress instrument, where the shear stress is applied and the resultant strain is measured, may be used. Examples of such instruments are the majority of the current rheometers, the main manufacturers being Anton Parr GmbH, Bohlin Instruments, a division of Malvern Instruments, ATS Rheosystems and TA Instruments. Such a rheometer provides a periodic measurement of viscosity at various plate rotation frequencies, ω, rather than the transient measurement of, for instance, a capillary viscometer. The reciprocating plate rheometer is able to measure both the in phase and out of phase fluid response to stress or displacement. The complex viscosity, η*, is defined as η* = η' - i η"; where η' = G"/ ω, η" = G'/ω and i is √-1, where G' is the storage modulus and G" is the loss modulus. Alternatively a viscometer that can measure only the transient measurement of, for instance, a capillary or shear viscosity, such as those made by Brookfield Engineering Laboratories or Cannon Instrument Company can also be used.

The ink compositions generally have melt viscosities at the jetting temperature (in one embodiment no lower than about 50°C, in another embodiment no lower than about 60°C, and in yet another embodiment no lower than about 70°C, and in one embodiment no higher than about 120°C, and in another embodiment no higher than about 110°C, although the jetting temperature can be outside of these ranges) in one embodiment of no more than about 30 centipoise, in another embodiment of no more than about 20 centipoise, and in yet another embodiment of no more than about 15 centipoise, and in one embodiment of no less than about 2 centipoise, in another embodiment of no less than about 5 centipoise, and in yet another embodiment of no less than about 7 centipoise, although the melt viscosity can be outside of these ranges.

In one specific embodiment, the inks are jetted at low temperatures, in particular at temperatures below about 110°C, in one embodiment from about 40°C to about 110°C, in another embodiment from about 50°C to about 110°C, and in yet another embodiment from about 60°C to about 90°C, although the jetting temperature can be outside of these ranges. At such low jetting temperatures, the conventional use of temperature differential between the jetted ink and the substrate upon which the ink is jetted to effect a rapid phase change in the ink (i.e., from liquid to solid) may not be effective. The gellant can thus be used to effect a rapid viscosity increase in the jetted ink upon the substrate. In particular, jetted ink droplets can be pinned into position on a receiving substrate that is maintained at a temperature cooler than the ink jetting temperature of the ink through the action of a phase change transition in which the ink undergoes a significant viscosity change from a liquid state to a gel state (or semi-solid state).

In some embodiments, the temperature at which the ink forms the gel state is any temperature below the jetting temperature of the ink, in one embodiment any temperature that is about 5°C or more below the jetting temperature of the ink. In one embodiment, the gel state can be formed at a temperature of at least about 25°C, and in another embodiment at a temperature of at least about 30°C, and in one embodiment of no more than about 100°C, in another embodiment of no more than about 70°C, and in yet another embodiment of no more than about 50°C, although the temperature can be outside of these ranges. A rapid and large increase in ink viscosity occurs upon cooling from the jetting temperature, at which the ink is in a liquid state, to the gel temperature, at which the ink is in the gel state. The viscosity increase is in one specific embodiment at least a 10^{2.5} -fold increase in viscosity.

The ultra-violet curable phase change marking materials can be prepared by any desired or suitable method. For example, the ink ingredients can be mixed together, followed by heating, to a temperature in one embodiment of at least about 80°C, and in one embodiment of no more than about 120°C, although the temperature can be outside of these ranges, and stirring until a homogeneous ink composition is obtained, followed by cooling the ink to ambient temperature (typically from about 20°C to about 25°C). The inks are gels at ambient temperature.

After printing the substrate with the ultra-violet curable phase change ink marking material and curing to provide a pattern of digital dams, the dams are filled with conductive material and the conductive material is annealed to form an electronic structure on the substrate. Optionally, the digital dams are removed.

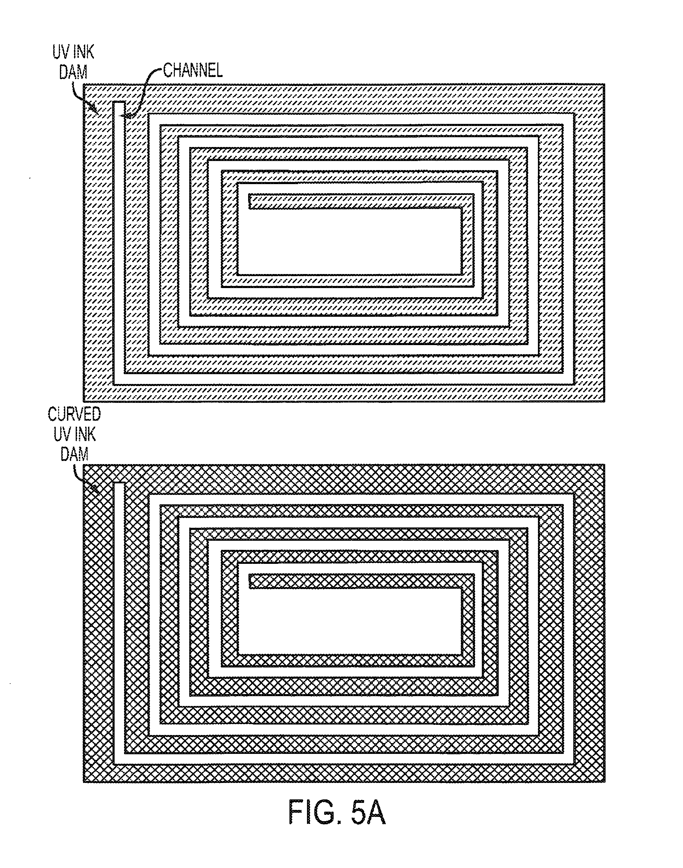

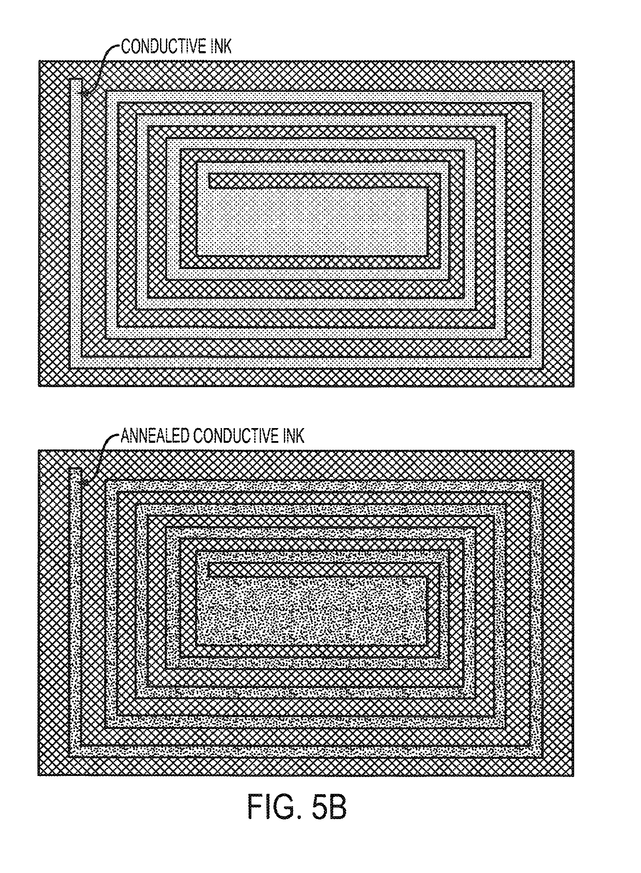

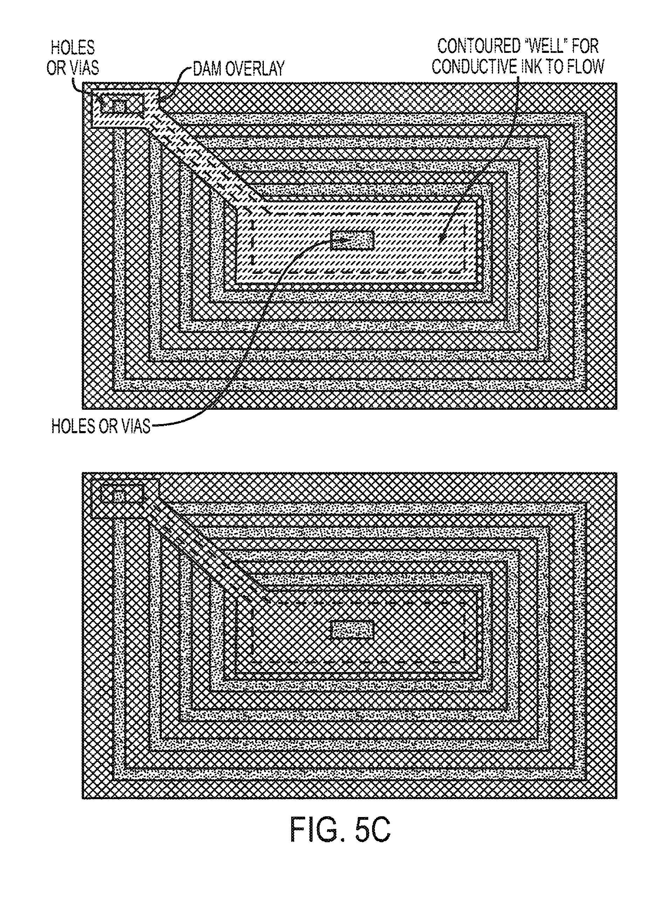

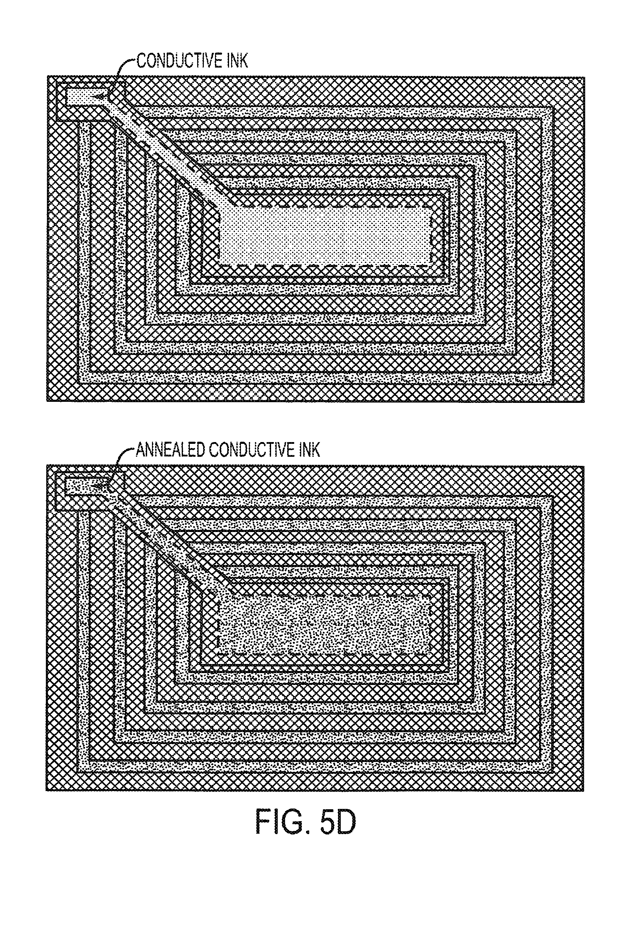

In some embodiments, it may be desired to retain a portion of the digital dam to allow annealing of another layer of conductive ink on top. In this case, a section of the digital dam acts as insulator, enabling the formation of a conductive overpass without creating a short circuit with the underlying conductive trace. This is especially useful for creating capacitor layers for RFID tags, for example. The radiation curable phase change gel ink can be printed with topographical 'hills' and 'valleys' that can serve to 'shape' the flow of the conductive ink in order to create insulating layers. Figures 5A through 5B illustrate a series of plates showing an embodiment where the digital dam behaves as an insulating layer. In Figure 5A, a channel is created by deposition of an ultraviolet curable gel phase change ink dam (top plate) in a desired pattern followed by curing (bottom plate). Conductive ink is then deposited in the dam created by the ultraviolet curable gel phase change ink dam and annealed, Figure 5B, top plate and bottom plate, respectively. A subsequent layer (or layers) of ultraviolet curable phase change gel ink is deposited to create a dam overly having holes or vias and a contoured well for conductive ink to flow as desired, as shown in Figure 5C, top plate. The dam overlay ultraviolet curable phase change gel ink is then cured, as shown in Figure 5C, bottom plate. Conductive ink is then deposited, Figure 5D (top plate) and annealed Figure 5D (bottom plate) and this process can be repeated as desired to create additional circuitry.

The conductive material can comprise any suitable material including, but not limited to, gold, silver, platinum, palladium, nickel, copper, cobalt, indium, tin, zinc, titanium, chromium, tantalum, tungsten, iron, rhodium, iridium, ruthenium, osmium, and lead. Further examples include nanoparticle ink material, for example wherein a nanoparticles composition comprising a metal which exhibits a low bulk resistivity such as, e.g., a bulk resistivity of less than about 15 micro-Ω cm, e.g., less than about 10 micro- Q cm, or less than about 5 micro- Q cm. Non-limiting examples of metals for use in nanoparticle ink materials include transition metals as well as main group metals such as, e.g., silver, gold, copper, nickel, cobalt, palladium, platinum, indium, tin, zinc, titanium, chromium, tantalum, tungsten, iron, rhodium, iridium, ruthenium, osmium, and lead. In embodiments, the conductive material comprises a nanoparticles ink comprising gold, silver, platinum, palladium, nickel, copper, cobalt, indium, tin, zinc, titanium, chromium, tantalum, tungsten, iron, rhodium, iridium, ruthenium, osmium, or lead. The conductive material can comprise, in embodiments, metal nanoparticles compositions disclosed in U. S. Patent Publication 20060189113 of Karel Vanheusden et al., Published August 24, 2006,. In addition, the conductive material can comprise metal nanoparticles having a core-shell structure. For example, the conductive material can comprise, in embodiments, metal nanoparticles compositions disclosed in U. S. Patent Publication 20070212562 of In-Keun Shim et al., Published September 13, 2007.

FIG. 1 shows a system 100 for creating a substrate 102 having a conductive structure thereon. An ultra-violet curable phase change marking material source 104, such as an ink jet printer, is provided for printing a pattern of fillable channels or dams on the substrate 102.

Any suitable substrate can be employed including plain papers such as XEROX® 4024 papers, XEROX® Image Series papers, Courtland 4024 DP paper, ruled notebook paper, bond paper, silica coated papers such as Sharp Company silica coated paper, JuJo paper, HAMMERMILL LASERPRINT® paper, and the like, glossy coated papers such as XEROX® Digital Color Gloss, Sappi Warren Papers LUSTROGLOSS®, and the like, transparency materials, fabrics, textile products, plastics, polymeric films, inorganic substrates such as metals, glass, and wood, as well as meltable or dissolvable substrates, such as waxes or salts, in the case of removable supports for free standing objects, and the like.

In embodiments, any desired printing system can be employed for patterning the digital dams including systems suitable for preparing three-dimensional objects, such as a solid object printer. In embodiments, the printer can comprise a thermal ink jet printer, piezoelectric ink jet printer, acoustic ink jet printer, thermal transfer printer, gravure printer, electrostatographic printing methods, and the like. In a specific embodiment the printer comprises a piezoelectric ink jet printing apparatus.

In embodiments, the printer described in U. S. Patent Publication 20080218540, of Gabriel Iftime, et al., published September 11, 2008 entirety, is employed. The ink jet printing apparatus described therein includes at least an ink jet print head and a print region surface toward which ink is jetted from the ink jet print head, wherein a height distance between the ink jet print head and the print region surface is adjustable. Therein, the ink jet print head is adjustable in spacing with respect to the print region surface so as to permit the ink jet print head to be moved from the a first position for regular height printing to a second height distance that is greater than (that is, the spacing between the ink jet print head and the print region surface is greater than) the first height distance. The second height distance is not fixed, and can be varied as necessary for a given printing. Moreover, the second height distance can itself be changed during a printing, as necessary. For example, it may be desirable to adjust the height distance from the first position to a second position as an image is built-up by the ink jet print head, and then as the image continues to be built-up, to adjust the ink jet print head from the second position to a third position in which the spacing from the print region surface is even further increased, and so on as necessary to complete build-up of the object.

The system and method herein comprise use of ultra-violet curable phase change marking material to create digital dams for preparing thick conductive lines of conductive ink within the channels. In embodiments, the printer 104 includes an x, y, z movable substrate stage. In three-dimensional printing, the printhead or target stage is movable in three dimensions, x, y, and z, enabling the preparation of a pattern of any desired size and configuration. In building up the channel pattern, multiple passes of the print head can be used to prepare channels by depositing successive layers of ink so that the pattern has a desired print height and geometry.

In embodiments, the ultra-violet curable phase change marking material is printed to form a pattern of fillable channels having a channel depth of from about 1 to about 50 micrometers, although the depth can be outside of this range. In embodiments, the pattern of fillable channels is creating using from about 1 to about 5 printing passes, although not limited.

Computer control of the ink jet print head or heads is employed to deposit the appropriate amount and/or layers of ink in the desired pattern so as to obtain the pattern with the desired print heights and overall geometries therein.

Curing device 106 is employed for curing the printed substrate by exposing the printed substrate to UV curable light. Any suitable curing device can be used, for example, a UV Fusion LC-6B Benchtop Conveyor equipped with UV Fusion Light Hammer 6 Ultraviolet Lamp System employing a "D" bulb, although not limited.

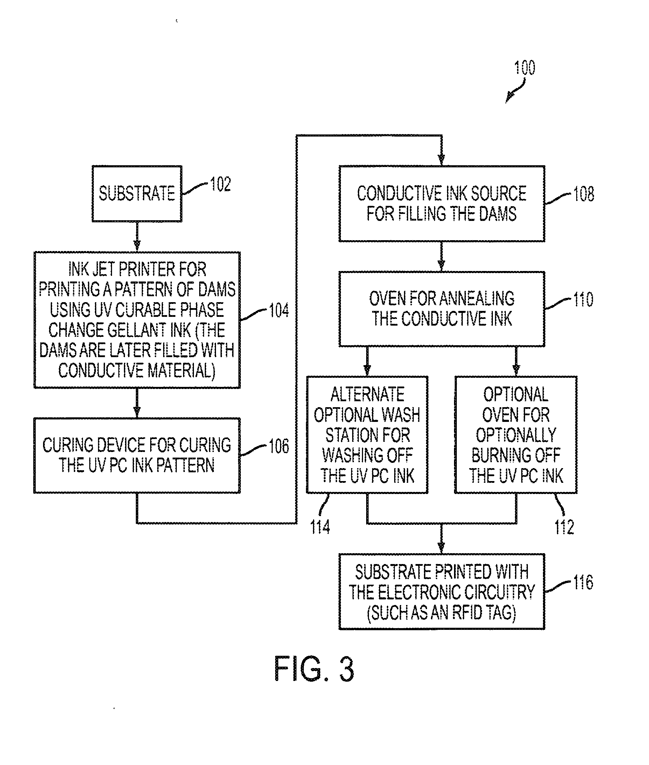

The channels can be filled with the conductive material using any suitable method such as by immersing the patterned substrate in a conductive material or by printing the conductive material. In embodiments, the conductive ink is deposited by printing the conductive ink using a single printing pass or using multiple printing passes. In Figure 3, conductive ink source 108 deposits conductive material into the fillable channels. The conductive ink source can comprise a printer or any other device suitable for disposing the conductive material into the channels such as a doctor blade or wiper. The conductive ink can also be depositing in a separate printing operation, or by an analog process such as with a flood coater.

Annealing device 110 is employed to anneal the deposited conductive ink to create a substrate having patterned conductive structure 116. Any suitable annealing device can be used, such as a hot plate or an oven.

Optionally, the ultra-violet curable phase change marking material can be removed, if desired. Any suitable device or method can be used to remove the ultra-violet curable phase change marking material. For example, oven 112 can be used to burn off the ultra-violet curable phase change marking material from the prepared substrate 116. In another embodiment, a wash station 114 can be used to wash off the ultra-violet curable phase change marking material with a solvent wash that is inert to the conductive marking material.

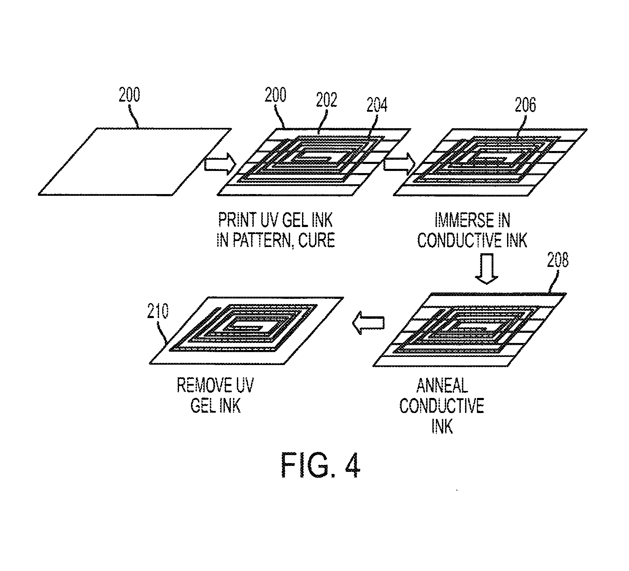

FIG. 4 is a flow diagram illustrating the present method for preparing conductive structures using phase change marking material. In FIG. 4, substrate 200 is printed with a pattern 202 of fillable channels 204 formed by printing ultra-violet curable gellant phase change marking material thereon. The printed substrate 200 is immersed in conductive ink providing filled channels 206. The conductive ink is annealed as shown at block 208. In block 210, the ultra-violet curable phase change marking material is removed.

### EXAMPLES

The following Examples are being submitted to further define various species of the present disclosure. These Examples are intended to be illustrative only and are not intended to limit the scope of the present disclosure. Also, parts and percentages are by weight unless otherwise indicated.

### Example 1

As a control experiment using commercial solid ink, a solid ink dam was prepared by jetting solid black ink (Phaser® 8860 black ink available from Xerox® Corporation) in a pattern on Xerox Durapaper® paper using a Phaser® 8400 solid ink printer, jetting at 112°C and 24kHz. Figure 6 is a micrograph of the printed dam. A copper nanoparticle ink was dispensed within the dam in a single pass using a micropipette. The copper nanoparticle ink was annealed on a hot plate (Super-Nuova Digital hotplate, from Thermo Scientific) at 150 °C for 15 minutes providing a conductive structure having a 10 ohm resistance measured using an Omega 880 handheld digital multimeter. FIG. 7 is a micrograph of the annealed ink.

### Example 2

A cyan ultra-violet curable phase change gellant ink A is prepared in accordance with the present disclosure as follows. An ultra-violet curable phase change gellant ink is prepared containing 7.5 percent by weight curable amide gellant as described in Example VIII of U. S. Patent 7,279,587, 5 percent by weight Unilin 350® acrylate wax prepared as described in U. S. Patent Publication 2007120925, 5 percent by weight pentafunctional acrylate monomer (SR 399LV® dipentaerythritol pentaacrylate available from Sartomer Co., Inc.), 52.8 percent by weight difunctional acrylate monomer (propoxylated neopentyl glycol diacrylate SR 9003® available from Sartomer Co., Inc.), 3 percent by weight IRGACURE® 379 photoinitiator (obtained from Ciba Specialty Chemicals), 1 percent by weight IRGACURE® 819 photoinitiator (obtained from Ciba Specialty Chemicals), 3.5 percent by weight IRGACURE® 127 photoinitiator (obtained from Ciba Specialty Chemicals), 2 percent by weight DAROCUR® ITX photoinitiator (obtained from Ciba Specialty Chemicals) 0.2 percent by weight UV stabilizer (IRGASTAB® UV10, obtained from Ciba Specialty Chemicals), and 20 percent by weight cyan pigment dispersion (a dispersion containing 15 weight percent cyan pigment/SR 9003®). All of the components are stirred together at 90°C for 1 hour.

A UV curable ink dam is prepared by jetting the ultra-violet curable cyan gellant ink A in a pattern on Xerox Durapaper® taped to the drum of a modified Phaser® 8400 printer, at a temperature of 85°C, and a jetting frequency of 24kHz. The final dam thickness after 7 passes is approximately 70 micrometers. The Durapaper® is removed from the drum, and the printed dam is cured by passing through a Fusions UV Lighthammer® available from Fusions UV Systems, Inc., equipped with a 600W mercury D-bulb at a conveyor belt speed of 10fpm. Next, a soluble silver precursor ink (Inktec® IJP-010, from InkTec Corporation) is applied to the dam using a micropipette. Through capillary action, the ink is drawn into the channels of the dam. The excess ink is wiped off, and, the dam containing the ink is heated to 120°C for 15 minutes to anneal the ink, forming a continuous conductive trace. The measured sheet resistance of the conductive area is 32.3 ohms/sq, measured using a CPS Resistivity Test Fixture fitted with a C4S 4-Point Probe Head (from Cascade Microtech Inc.) connected to a Keithley 236 source measure unit digital multimeter

### Example 3

A clear ultra-violet curable phase change gellant ink composition B is prepared in accordance with the present disclosure as follows. An ultra-violet curable phase change gellant ink is prepared containing 7.5 percent by weight curable amide gellant as described in Example VIII of U. S. Patent 7,279,587, 5 percent by weight Unilin 350® acrylate wax prepared as described in U. S. Patent Publication 2007120925, 5 percent by weight pentafunctional acrylate monomer (SR 399LV® dipentaerythritol pentaacrylate available from Sartomer Co., Inc.), 77.8 percent by weight difunctional acrylate monomer (propoxylated neopentyl glycol diacrylate SR 9003® available from Sartomer Co., Inc.), 1 percent by weight IRGACURE® 819 photoinitiator (obtained from Ciba Specialty Chemicals), 3.5 percent by weight IRGACURE® 127 photoinitiator (obtained from Ciba Specialty Chemicals), and 0.2 percent by weight UV stabilizer (IRGASTAB® UV10, obtained from Ciba Specialty Chemicals. All of the components are stirred together at 90°C for 1 hour.

An ultra-violet curable ink dam is prepared by jetting the ultra-violet curable clear gel ink B in a pattern on Xerox Durapaper® taped to the drum of a modified Phaser® 8400 printer, at a temperature of 85°C, and a jetting frequency of 24kHz. The final dam thickness after 7 passes is approximately 70 micrometers. The Durapaper® is removed from the drum, and the printed dam is cured by passing through a Fusions UV Lighthammer® available from Fusions UV Systems, Inc., equipped with a 600W mercury D-bulb at a conveyor belt speed of 10fpm. Next, a soluble silver precursor ink (Inktec® IJP-010, from InkTec Corporation) is applied to the dam using a micropipette. Through capillary action, the ink is drawn into the channels of the dam. The excess ink is wiped off and the dam containing the ink is heated to 120°C for 15 minutes to anneal the ink, forming a continuous conductive trace. The measured sheet resistance of the conductive area is 30.1 ohms/sq, measured using a CPS Resistivity Test Fixture fitted with a C4S 4-Point Probe Head (from Cascade Microtech, Inc.) connected to a Keithley 236 source measure unit digital multimeter

## Claims

1. A method for preparing conductive structures on a substrate comprising:
printing a radiation curable phase change gel marking material in a pattern of fillable channels on a surface of a substrate,
curing the radiation curable phase change gel marking material:
depositing a conductive material in the fillable channels;
annealing the conductive material; and
optionally, removing the radiation curable phase change gel marking material.
wherein the curable phase change gel marking material comprises an electron-beam radiation curable marking material, a thermal curable marking material, or an ultraviolet curable phase change gellant ink.

2. The method of claim 1, wherein printing an ultra-violet curable phase change marking material comprises printing with a piezoelectric ink jet printing apparatus.

3. The method of claim 1, wherein the conductive structures comprise electronic circuitry, or radio-frequency identification tags.

4. The method of claim 1, wherein the radiation curable phase change gel marking material is an electron-beam radiation curable marking material, a thermal curable marking material, or an ultraviolet curable phase change gellant ink.

5. The method of claim 1, wherein the ultra-violet curable phase change marking material comprises an optional colorant and a phase change ink vehicle comprising a radiation curable monomer or prepolymer; a photoinitiator; a reactive wax; and a gellant.

6. The method of claim 1, wherein the fillable channels have a channel depth of from about 1 to about 50 micrometers, or
wherein the pattern of fillable channels is created using from 1 to 5 printing passes.

7. The method of claim 1, wherein the conductive material is deposited by immersing the patterned substrate in a conductive material; or
wherein the conductive material is deposited by printing the conductive material.

8. The method of claim 1, wherein the conductive material comprises a nanoparticle ink comprising gold, silver, platinum, palladium, nickel, copper, cobalt, indium, tin, zinc, titanium, chromium, tantalum, tungsten, iron, rhodium, iridium, ruthenium, osmium, or lead.

9. The method of claim 1, wherein the substrate is selected from the group consisting of plain paper, ruled notebook paper, bond paper, silica coated paper, glossy coated paper, transparency materials, fabrics, textile products, plastics, polymeric films, metal, glass, and wood.

10. A system for preparing conductive structures on a substrate comprising:
a curable phase change gel marking material source to print the curable phase change gel marking material in a pattern on a surface of a substrate wherein the pattern creates fillable channels;
a curing device for curing the curable phase change gel masking material;
a conductive material source to deposit the conductive material in the fillable channels;
a heat source for annealing the conductive material; and
optionally, a device for removing the curable phase change gel marking material.
wherein the curable phase change gel marking material comprises an electron-beam radiation curable marking material, a thermal curable marking material, or an ultraviolet curable phase change gellant ink.

11. The system of claim 10, wherein the curable phase change gel marking material source is a piezo-electric ink jet printer, or
wherein the curable phase change gel marking material source is an ink jet printer having programmable print heads for building up a pattern of fillable channels using from 1 to 5 printing passes, or
wherein the curable phase change gel marking material source is an ink jet printer capable of printing a pattern of fillable channels having a channel depth of from about 1 to about 50 micrometers.

12. The system of claim 10, wherein the curable phase change gel marking material comprises an optional colorant and a phase change ink vehicle comprising a radiation curable monomer or prepolymer; a photoinitiator; a reactive wax; and a gellant.

13. The system of claim 10, wherein the conductive material comprises a nanoparticle ink comprising gold, silver, platinum, palladium, nickel, copper, cobalt, indium, tin, zinc, titanium, chromium, tantalum, tungsten, iron, rhodium, iridium, ruthenium, osmium, lead.

14. The system of claim 10, wherein the substrate is selected from the group consisting of plain paper, ruled notebook paper, bond paper, silica coated paper, glossy coated paper, transparency materials, fabrics, textile products, plastics, polymeric films, metal, glass, and wood.

15. The system of claim 10, wherein the conductive features comprise radio-frequency identification tags.

## Patentansprüche

1. Verfahren zum Herstellen von leitfähigen Strukturen auf einem Substrat, umfassend:
Drucken eines durch Strahlung härtbaren Phasenänderungsgelmarkiermaterials in einem Muster aus verfüllbaren Kanälen auf einer Oberfläche eines Substrates;
Härten des durch Strahlung härtbaren Phasenänderungsgelmarkiermaterials;
Aufbringen eines leitfähigen Materials in den verfüllbaren Kanälen;
Wärmebehandeln des leitfähigen Materials; und
optionales Entfernen des durch Strahlung härtbaren Phasenänderungsgelmarkiermaterials,
wobei das härtbare Phasenänderungsgelmarkiermaterial ein durch Elektronenstrahlstrahlung härtbares Markiermaterial, ein thermisch härtbares Markiermaterial oder eine ultraviolett härtbare Phasenänderungsgelbildnertinte umfasst.

2. Verfahren nach Anspruch 1, wobei das Drucken eines ultraviolett härtbaren Phasenänderungsmarkiermaterials ein Drucken mit einer piezoelektrischen Tintenstrahldruckeinrichtung umfasst.

3. Verfahren nach Anspruch 1, wobei die leitfähigen Strukturen elektronische Schaltkreise oder Funkfrequenzidentifikations-Tags umfassen.

4. Verfahren nach Anspruch 1, wobei das durch Strahlung härtbare Phasenänderungsgelmarkiermaterial ein durch Elektronenstrahlstrahlung härtbares Markiermaterial, ein thermisch härtbares Markiermaterial oder eine ultraviolett härtbare Phasenänderungsgelbildnertinte ist.

5. Verfahren nach Anspruch 1, wobei das ultraviolett härtbare Phasenänderungsmarkiermaterial einen optionalen Farbstoff und einen Phasenänderungstintenträger umfasst, der ein durch Strahlung härtbares Monomer oder Vorpolymer, einen Fotoinitiator, ein reaktives Wachs und einen Gelbildner umfasst.

6. Verfahren nach Anspruch 1,
wobei die verfüllbaren Kanäle eine Kanaltiefe von etwa 1 bis etwa 50 µm aufweisen; oder
wobei das Muster aus verfüllbaren Kanälen unter Verwendung von ein bis fünf Druckdurchgängen hergestellt wird.

7. Verfahren nach Anspruch 1,
wobei das leitfähige Material durch Eintauchen des gemusterten Substrates in ein leitfähiges Material aufgebracht wird; oder
wobei das leitfähige Material durch Drucken des leitfähigen Materials aufgebracht wird.

8. Verfahren nach Anspruch 1, wobei das leitfähige Material eine Nanopartikeltinte umfasst, die Gold, Silber, Platin, Palladium, Nickel, Kupfer, Kobalt, Indium, Zinn, Zink, Titan, Chrom, Tantal, Wolfram, Eisen, Rhodium, Iridium, Ruthenium, Osmium oder Blei umfasst.

9. Verfahren nach Anspruch 1, wobei das Substrat aus einer Gruppe ausgewählt ist, die aus normalem bzw. unliniertem Papier, liniertem Notizblockpapier, Hartpostpapier (bond paper), mit Siliziumoxid beschichtetem Papier, glänzendem beschichtetem Papier, transparenten Materialien, Stoffen, Textilerzeugnissen, Kunststoffen, Polymerfilmen, Metall, Glas und Holz besteht.

10. System zum Herstellen von leitfähigen Strukturen auf einem Substrat, umfassend:
eine Quelle für härtbares Phasenänderungsgelmarkiermaterial zum Drucken des härtbaren Phasenänderungsgelmarkiermaterials in einem Muster auf eine Oberfläche eines Substrates, wobei das Muster verfüllbare Kanäle erzeugt;
eine Härtvorrichtung zum Härten des härtbaren Phasenänderungsgelmaskiermaterials;
eine Quelle für leitfähiges Material zum Aufbringen des leitfähigen Materials in den verfüllbaren Kanälen;
eine Wärmequelle zum Wärmebehandeln des leitfähigen Materials; und
optional eine Vorrichtung zum Entfernen des härtbaren Phasenänderungsgelmarkiermaterials,
wobei das härtbare Phasenänderungsgelmarkiermaterial ein durch Elektronenstrahlstrahlung härtbares Markiermaterial, ein thermisch härtbares Markiermaterial oder eine ultraviolett härtbare Phasenänderungsgelbildnertinte umfasst.

11. System nach Anspruch 10,
wobei die Quelle für härtbares Phasenänderungsgelmarkiermaterial ein piezoelektrischer Tintenstrahldrucker ist; oder
wobei die Quelle für härtbares Phasenänderungsgelmarkiermaterial ein Tintenstrahldrucker ist, der programmierbare Druckköpfe zum Aufbauen eines Musters aus verfüllbaren Kanälen unter Verwendung von ein bis fünf Druckdurchgängen aufweist; oder
wobei die Quelle für härtbares Phasenänderungsgelmarkiermaterial ein Tintenstrahldrucker ist, der dazu in der Lage ist, ein Muster aus verfüllbaren Kanälen mit einer Kanaltiefe von etwa 1 bis etwa 50 µm zu drucken.

12. System nach Anspruch 10, wobei das härtbare Phasenänderungsgelmarkiermaterial einen optionalen Farbstoff und einen Phasenänderungstintenträger umfasst, der ein durch Strahlung härtbares Monomer oder Vorpolymer, einen Fotoinitiator, ein reaktives Wachs und einen Gelbildner umfasst.

13. System nach Anspruch 10, wobei das leitfähige Material eine Nanopartikeltinte umfasst, die Gold, Silber, Platin, Palladium, Nickel, Kupfer, Kobalt, Indium, Zinn, Zink, Titan, Chrom, Tantal, Wolfram, Eisen, Rhodium, Iridium, Ruthenium, Osmium, Blei umfasst.

14. System nach Anspruch 10, wobei das Substrat aus einer Gruppe ausgewählt ist, die aus normalem bzw. unliniertem Papier, liniertem Notizblockpapier, Hartpostpapier (bond paper), mit Siliziumoxid beschichtetem Papier, glänzendem beschichtetem Papier, transparenten Materialien, Stoffen, Textilerzeugnissen, Kunststoffen, Polymerfilmen, Metall, Glas und Holz besteht.

15. System nach Anspruch 10, wobei die leitfähigen Merkmale Funkfrequenzidentifikations-Tags umfassen.

## Revendications

1. Procédé permettant de préparer des structures conductrices sur un substrat comprenant le fait :
d'imprimer un matériau gel de marquage à changement de phase durcissable par irradiation selon un motif de canaux pouvant être remplis sur une surface d'un substrat ;
de durcir le matériau gel de marquage à changement de phase durcissable par irradiation ;
de déposer un matériau conducteur dans les canaux pouvant être remplis ;
de recuire le matériau conducteur ; et
d'éliminer éventuellement le matériau gel de marquage à changement de phase durcissable par irradiation, où le matériau gel de marquage à changement de phase durcissable comprend un matériau de marquage durcissable par irradiation de faisceau d'électrons, un matériau de marquage thermodurcissable, ou une encre gélifiante à changement de phase durcissable par ultraviolet.

2. Procédé de la revendication 1, dans lequel l'impression d'un matériau de marquage à changement de phase durcissable par ultraviolet comprend le fait d'imprimer avec un appareil d'impression à jet d'encre piézoélectrique.

3. Procédé de la revendication 1, dans lequel les structures conductrices comprennent une circuiterie électronique, ou des étiquettes d'identification par radiofréquence.

4. Procédé de la revendication 1, dans lequel le matériau gel de marquage à changement de phase durcissable par irradiation est un matériau de marquage durcissable par irradiation de faisceau d'électrons, un matériau de marquage thermodurcissable, ou une encre gélifiante à changement de phase durcissable par ultraviolet.

5. Procédé de la revendication 1, dans lequel le matériau de marquage à changement de phase durcissable par ultraviolet comprend un colorant facultatif et un véhicule d'encre à changement de phase comprenant un monomère ou un prépolymère durcissable par irradiation ; un photoinitiateur ; une cire réactive ; et un gélifiant.

6. Procédé de la revendication 1, dans lequel les canaux pouvant être remplis ont une profondeur de canal d'environ 1 à environ 50 micromètres, ou
dans lequel le motif de canaux pouvant être remplis est créé en utilisant de 1 à 5 passages d'impression.

7. Procédé de la revendication 1, dans lequel le matériau conducteur est déposé par immersion du substrat à motifs dans un matériau conducteur ; ou
dans lequel le matériau conducteur est déposé par impression du matériau conducteur.

8. Procédé de la revendication 1, dans lequel le matériau conducteur comprend une encre à nanoparticules comprenant de l'or, de l'argent, du platine, du palladium, du nickel, du cuivre, du cobalt, de l'indium, de l'étain, du zinc, du titane, du chrome, du tantale, du tungstène, du fer, du rhodium, de l'iridium, du ruthénium, de l'osmium, ou du plomb.

9. Procédé de la revendication 1, dans lequel le substrat est choisi du groupe constitué du papier ordinaire, du papier réglé pour bloc-notes, du papier bond, du papier enrobé de silice, du papier couché brillant, des matériaux transparents, des toiles synthétiques, des produits textiles, des matières plastiques, des films polymères, du métal, du verre, et du bois.

10. Système permettent de préparer des structures conductrices sur un substrat comprenant :
une source de matériau gel de marquage à changement de phase durcissable pour imprimer le matériau gel de marquage à changement de phase durcissable selon un motif sur une surface d'un substrat où le motif crée des canaux pouvant être remplis ;
un dispositif de durcissement pour durcir le matériau gel de marquage à changement de phase durcissable ;
une source de matériau conducteur pour déposer le matériau conducteur dans les canaux pouvant être remplis ;
une source de chaleur pour recuire le matériau conducteur ; et
éventuellement, un dispositif pour enlever le matériau gel de marquage à changement de phase durcissable, où le matériau gel de marquage à changement de phase durcissable comprend un matériau de marquage durcissable par irradiation de faisceau d'électrons, un matériau de marquage thermodurcissable, ou une encre gélifiante à changement de phase durcissable par ultraviolet.

11. Système de la revendication 10, dans lequel la source de matériau gel de marquage à changement de phase durcissable est une imprimante à jet d'encre piézoélectrique, ou
dans lequel la source de matériau gel de marquage à changement de phase durcissable est une imprimante à jet d'encre ayant des têtes d'impression programmables pour constituer un motif de canaux pouvant être remplis en utilisant de 1 à 5 passages d'impression, ou
dans lequel la source de matériau gel de marquage à changement de phase durcissable est une imprimante à jet d'encre capable d'imprimer un motif de canaux pouvant être remplis ayant une profondeur de canal d'environ 1 à environ 50 micromètres.

12. Système de la revendication 10, dans lequel le matériau gel de marquage à changement de phase durcissable comprend un colorant facultatif et un véhicule d'encre à changement de phase comprenant un monomère ou un prépolymère durcissable par irradiation ; un photoinitiateur ; une cire réactive ; et un gélifiant.

13. Système de la revendication 10, dans lequel le matériau conducteur comprend une encre à nanoparticules comprenant de l'or, de l'argent, du platine, du palladium, du nickel, du cuivre, du cobalt, de l'indium, de l'étain, du zinc, du titane, du chrome, du tantale, du tungstène, du fer, du rhodium, de l'iridium, du ruthénium, de l'osmium, ou du plomb.

14. Système de la revendication 10, dans lequel le substrat est choisi du groupe constitué du papier ordinaire, du papier réglé pour bloc-notes, du papier bond, du papier enrobé de silice, du papier couché brillant, des matériaux transparents, des toiles synthétiques, des produits textiles, des matières plastiques, des films polymères, du métal, du verre, et du bois.

15. Système de la revendication 10, dans lequel les caractéristiques conductrices comprennent des étiquettes d'identification par radiofréquence.
